# EUROPEAN PATENT APPLICATION

(11) **EP 4 745 669 A2**
(43) Date of publication of application: **20.05.2026**
(21) Application number: 25215994.2
(22) Date of filing: 14.11.2025
(51) Int. Cl.: G03F 7/20

(54) **SPATIAL VIRTUAL METROLOGY FOR OVERLAY PREDICTION USING MULTIMODAL MACHINE DATA**

(30) Priority: 15.11.2024 US 202463720923 P; 03.11.2025 US 202519377428
(71) Applicant: Gauss Labs Inc., Palo Alto, CA 94301 (US)
(72) Inventor: PARK, Wonhui, Seoul (KR); JO, Pil Sung, Seoul (KR); CHANG, Wonsang, Seoul (KR); LEE, Jae-Han, Seoul (KR); KIM, Il Koo, Seoul (KR)
(74) Representative: Carpmaels & Ransford LLP

(57) **Abstract**

Described are systems and methods for predicting an overlay of a patterned wafer. Methods can include receiving a machine data set comprising parameters at a plurality of positions of a wafer, generating an integrated data set by aggregating the parameters and mapping the aggregated parameters to an equispatial grid, generating, using a trained machine learning (ML) model, a predicted overlay for the patterned wafer based at least in part on processing the integrated data set.

## Description

### CROSS-REFERENCE TO RELATED APPLICATIONS

The present application claims the benefit of U.S. Provisional Application No. 63/720,923, filed November 15, 2024, which is incorporated by reference herein in its entirety.

### BACKGROUND

Typical systems and methods in semiconductor manufacturing may infrequently measure an overlay of a patterned wafer. Low sampling can allow wafers that are out of specification (or spec-out) to pass to the next process without rework thereby reducing yield during manufacturing. Also, such low sampling can require reworking spec-out wafers thereby increasing costs during manufacturing. Further, each overlay can take appreciable time to measure. Such time-consuming measurements can make sampling more patterned wafers impractical.

Accordingly, there is an unmet need for technical solutions that can address at least these technical challenges.

### SUMMARY

Systems and methods herein can provide technical solutions for solving technical challenges during metrology (e.g., predicting or measuring an overlay of a patterned wafer) thereby improving yield and lowering costs in semiconductor manufacturing. In some cases, systems and methods herein can be referred to as spatial virtual metrology (VM).

In an aspect, disclosed herein is a method for predicting an overlay of a wafer, the method comprising: (a) receiving a machine data set comprising parameters at a plurality of positions of a wafer, wherein the wafer is to be patterned by a machine to yield a patterned wafer; (b) generating an integrated data set by (i) aggregating the parameters and (ii) mapping the aggregated parameters to an equispatial grid; (c) generating, using a trained machine learning (ML) model, a predicted overlay for the patterned wafer based at least in part on processing the integrated data set; and (d) inferring a statistical deviation of the predicted overlay from a normally patterned wafer. In some embodiments, the machine data set is a multimodal data set comprising alignment data, leveling data, lens data, servo data, advanced process control (APC) data, or fault detection and classification (FDC) data. In some embodiments, the plurality of positions of the machine data set comprises positions across the patterned wafer that are random, uniformly distributed, or nonuniformly distributed. In some embodiments, the method further comprises applying an estimation function to the predicted overlay to predict a measurement at a plurality of other positions different than the plurality of positions of the predicted overlay. In some embodiments, the plurality of other positions of the predicted overlay comprises positions across the patterned wafer that are random, uniformly distributed, or nonuniformly distributed. In some embodiments, the method further comprises re-patterning the patterned wafer when the statistical deviation is determined to be outside a prescribed threshold. In some embodiments, the method further comprises using the predicted overlay to adjust parameters of the machine before patterning a subsequent wafer by the machine. In some embodiments, the method further comprises using the predicted overlay to predict a drift or a shift in the machine or processes of the machine. In some embodiments, measurements of the overlay or the predicted overlay comprise a critical dimension (CD) or a film thickness. In some embodiments, measurements of the overlay or the predicted overlay comprise a spatial difference or a displacement between layers of the patterned wafer. In some embodiments, the method further comprises using the predicted overlay to predict an anomaly in the patterned wafer. In some embodiments, the method further comprises, before patterning a subsequent wafer, using the predicted overlay to adjust (i) one or more parameters of the machine or (ii) one or more process parameters of the machine. In some embodiments, a process of the machine comprises a lithography process, an etching process, or a thin film process. In some embodiments, the method further comprises adjusting a density of the equispatial grid based at least on user-defined criteria or the statistical deviation. In some embodiments, the predicted overlay is operable for performing advanced process control (APC) by: using the predicted overlay to determine parameters of the APC; and adjusting parameters of the machine in real time based at least on using the determined parameters, wherein the adjusted parameters improve a yield of subsequent wafers to be patterned by the machine by at least 1%. In some embodiments, the trained ML model is trained using at least one or more of (i) the equispatial grid, (ii) the integrated data set, or (iii) a measured overlay of the patterned wafer. In some embodiments, the method further comprises using transfer learning to update a portion of the trained ML model before patterning a subsequent wafer, wherein the transfer learning is based at least on analyzing recent trends between the machine data set and the measured overlay. In some embodiments, the method further comprises training the ML model using one or more machine data sets comprising parameters from two or more machines used to pattern the wafer. In some embodiments, the method further comprises training the ML model using one or more overlays comprising measurements from two or more machines used to pattern the wafer. In some embodiments, the trained ML model is a deep neural network comprising: an encoder layer configured to obtain (i) global context features of the patterned wafer and (ii) intra-input feature correlation; a decoder layer configured to determine the global context features of the patterned wafer; and a skip connection layer configured to use at least local context features and the intra-input feature correlation to generate the predicted overlay. In some embodiments, the trained ML model is configured to preserve a spatial scale of any feature of the predicted overlay. In some embodiments, the statistical deviation comprises a mean deviation or a sigma deviation. In some embodiments, the predicted overlay is operable for performing virtual metrology (VM), root cause analysis (RCA), or image metrology (IM). In some embodiments, the method further comprises repeating (a) - (d) until all layers of the patterned wafer are patterned by the machine.

In another aspect, disclosed herein is a computer program product for predicting an overlay of a wafer, the computer program product comprising at least one non-transitory computer-readable medium having computer-readable program code portions embodied therein, the computer-readable program code portions comprising: an executable portion configured to receive a machine data set comprising parameters at a plurality of positions of a wafer, wherein the wafer is to be patterned by a machine to yield a patterned wafer; an executable portion configured to generate an integrated data set by (i) aggregating the parameters and (ii) mapping the aggregated parameters to an equispatial grid; an executable portion configured to generate, using a trained machine learning (ML) model, a predicted overlay for the patterned wafer based at least in part on processing the integrated data set; and an executable portion configured to infer a statistical deviation of the predicted overlay from a normally patterned wafer.

In another aspect, disclosed herein is a system for predicting an overlay of a wafer comprising at least one processor and instructions executable by the at least one processor to cause the at least one processor to perform operations comprising: (a) receiving a machine data set comprising parameters at a plurality of positions of a wafer, wherein the wafer is to be patterned by a machine to yield a patterned wafer; (b) generating an integrated data set by (i) aggregating the parameters and (ii) mapping the aggregated parameters to an equispatial grid; (c) generating, using a trained machine learning (ML) model, a predicted overlay for the patterned wafer based at least in part on processing the integrated data set; and (d) inferring a statistical deviation of the predicted overlay from a normally patterned wafer.

Additional aspects and advantages of the present disclosure will become readily apparent from the following detailed description, wherein only illustrative embodiments of the present disclosure are shown and described. As will be realized, the present disclosure is capable of other and different embodiments, and its several details are capable of modifications in various obvious respects, all without departing from the present disclosure. Accordingly, the drawings and description are to be regarded as illustrative in nature and not as restrictive.

### INCORPORATION BY REFERENCE

All publications, patents, and patent applications mentioned in this specification are herein incorporated by reference to the same extent as if each individual publication, patent, or patent application was specifically and individually indicated to be incorporated by reference. To the extent publications and patents or patent applications incorporated by reference contradict the present disclosure contained in the specification, the specification is intended to supersede and/or take precedence over any such contradictory material.

### BRIEF DESCRIPTION OF THE DRAWINGS

The novel features of the present disclosure are set forth with particularity in the appended claims. A better understanding of the features and advantages of the present disclosure will be obtained by reference to the following detailed description that sets forth illustrative embodiments, in which the principles of the present disclosure are utilized, and the accompanying drawings of which:

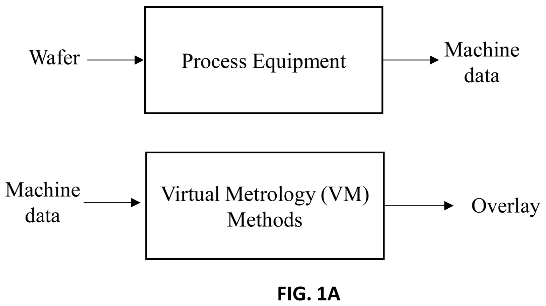

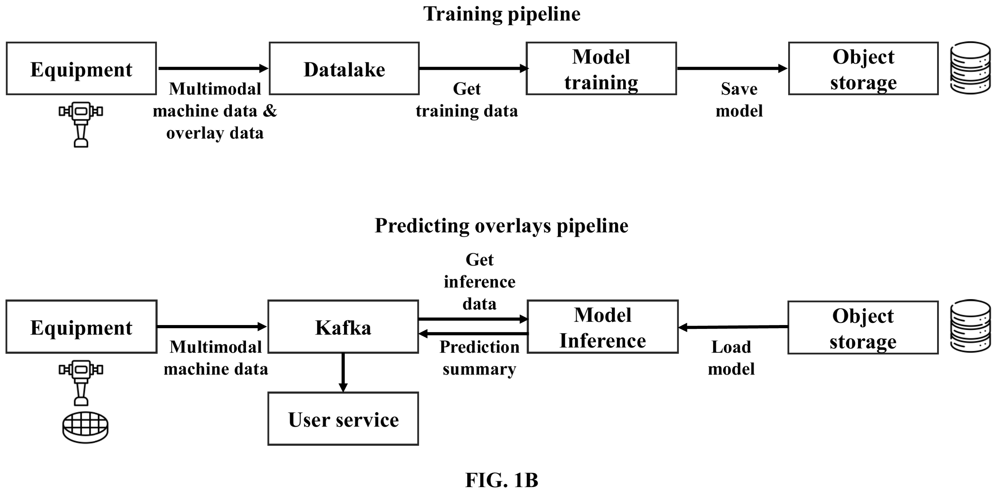

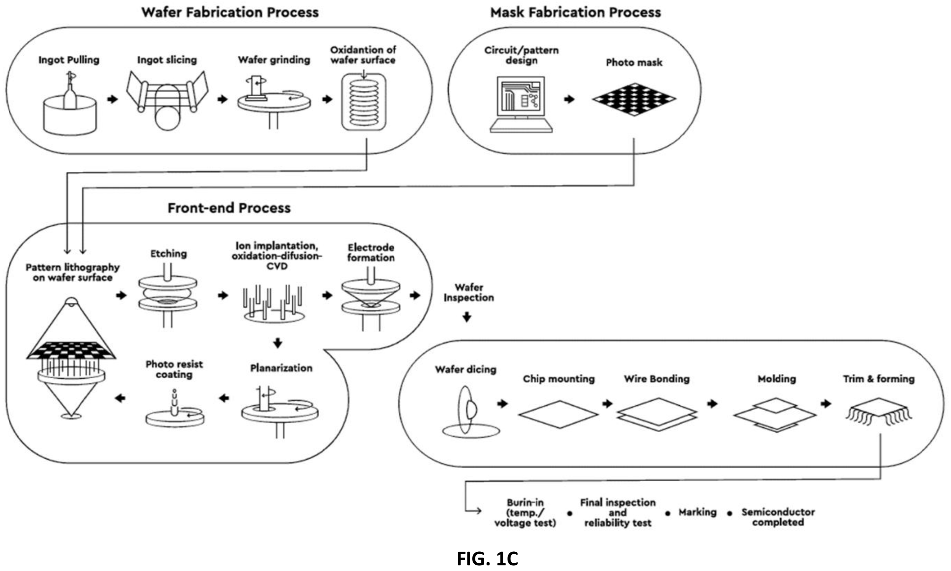

**FIGs. 1A-1C** depict an example architectures or pipelines configured to perform spatial virtual metrology (VM) methods for predicting an overlay of a wafer, in accordance with some embodiments. **FIG. 1A** depicts an example high-level architecture or pipeline, which can be configured to perform methods herein for determining or receiving multimodal machine data from processing equipment or processes in manufacturing environments and using the multimodal machine data to predict overlays with high spatial density. **FIG. 1B** depicts an example low-level architecture or pipeline, which can be configured to perform methods herein for training a machine learning (ML) model to predict an overlay of a wafer. **FIG. 1C** depicts different process equipment and processes that can be used to yield a patterned wafer.

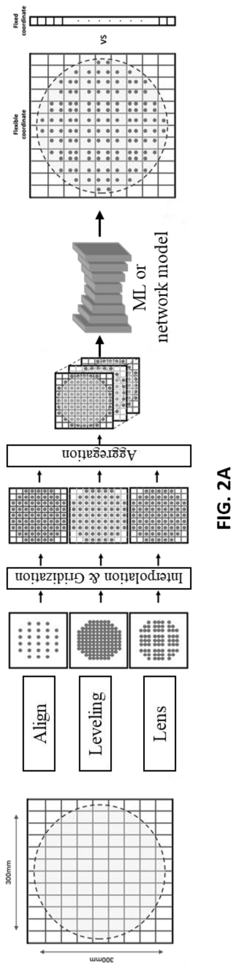

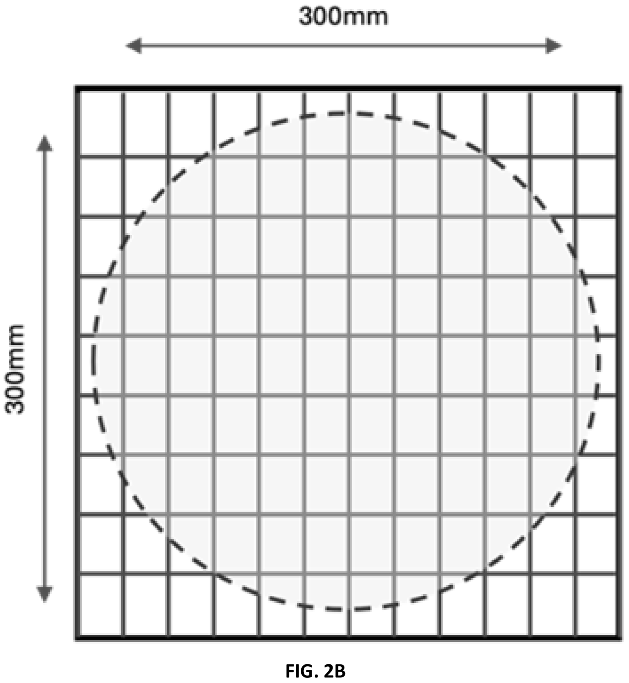

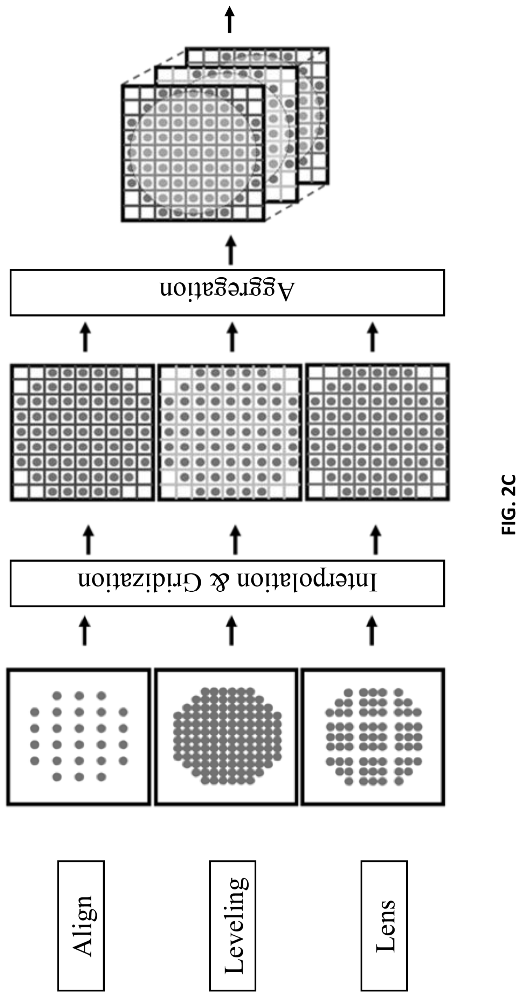

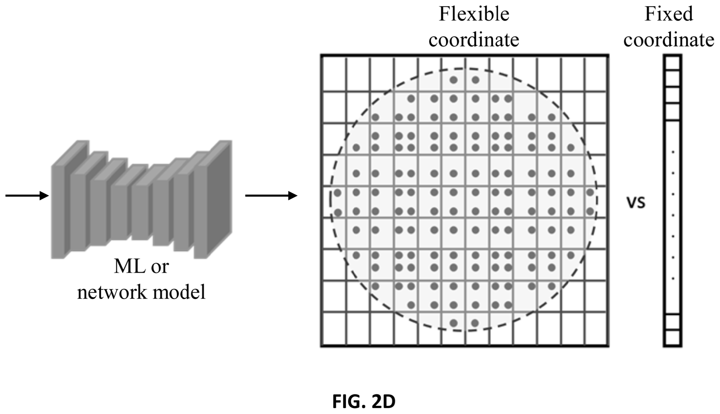

**FIGs. 2A-2D** depict an example spatial virtual metrology (VM) method for predicting an overlay of a wafer, in accordance with some embodiments. **FIG. 2A** depicts the example method, which can include using multimodal machine data to generate an integrated grid (or an equispatial grid) for training a machine learning (ML) model to predict an overlay of a wafer, e.g., a 300 millimeter (mm) by 300 mm wafer. **FIG. 2B** further depicts the example method, which can include overlaying a wafer with the integrated grid. **FIG. 2C** further depicts the example method, which can include using alignment data, leveling data, or lens data to generate a plurality of integrated grids for use as input features to train the ML model. **FIG. 2D** further depicts the example method, which can include outputting the predicted overlay as a flexible overlay for predicting data (e.g., overlay measurements) at any coordinate of the wafer or the integrated grid.

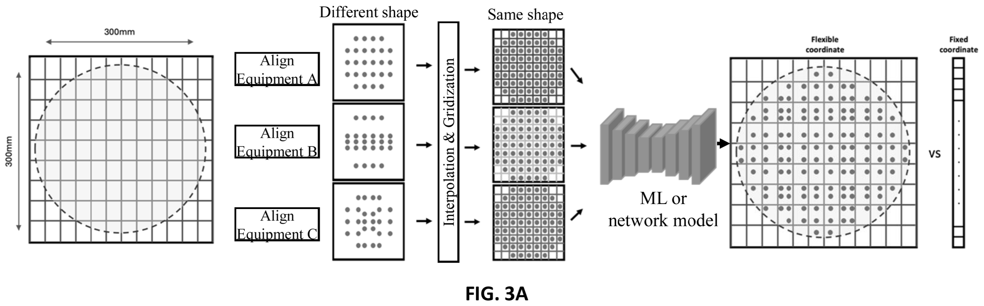

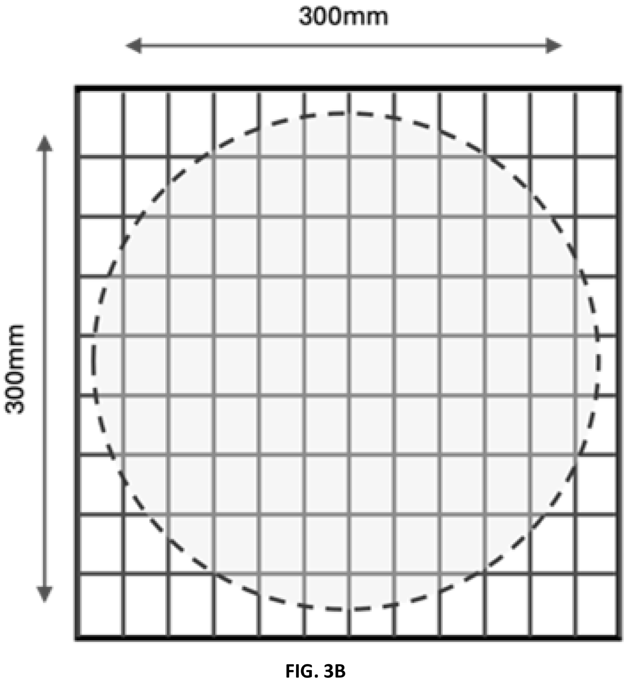

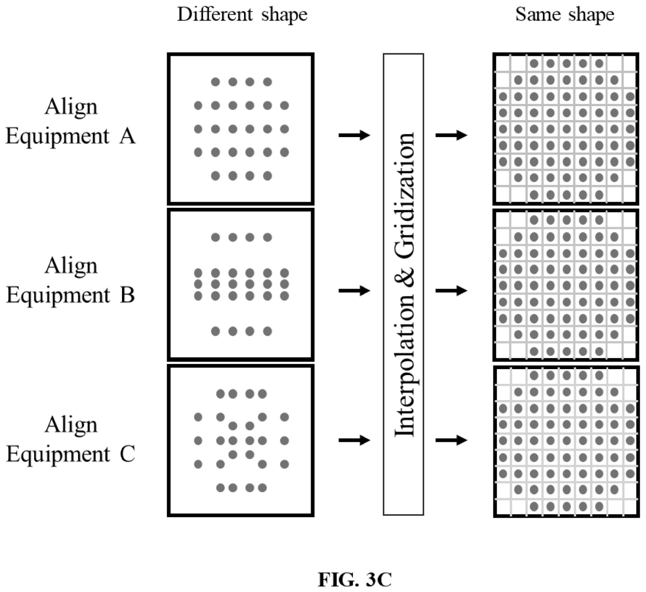

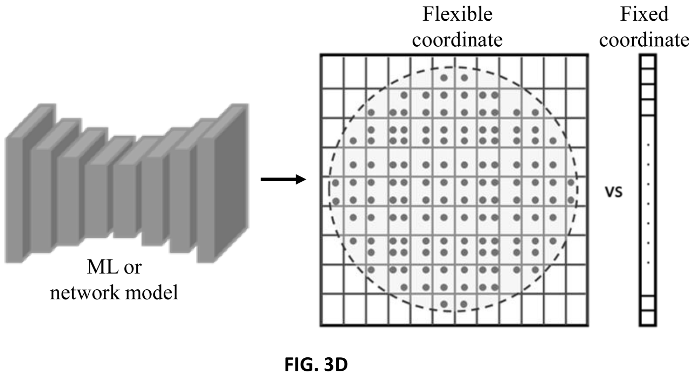

**FIGs. 3A-3D** depict an example spatial virtual metrology (VM) for predicting an overlay of a wafer, in accordance with some embodiments. **FIG. 3A** depicts the example method, which can include using multimodal machine data to generate an integrated grid (or an equispatial grid) for training a machine learning (ML) model to predict an overlay of a wafer, e.g., a 300 millimeter (mm) by 300 mm wafer. **FIG. 3B** further depicts the example method, which can include overlaying a wafer with the integrated grid. **FIG. 3C** further depicts the example method, which can include using alignment data from a plurality of processing equipment (e.g., equipment A, B, and C) or processes, leveling data from a plurality of processing equipment or processes, or lens data from a plurality of processing equipment or processes. The data can be used to generate a plurality of integrated grids for use as input features to train the ML model. **FIG. 3D** further depicts the example method, which can include outputting the predicted overlay as a flexible overlay for predicting data (e.g., overlay measurements) at any coordinate of the wafer or the integrated grid.

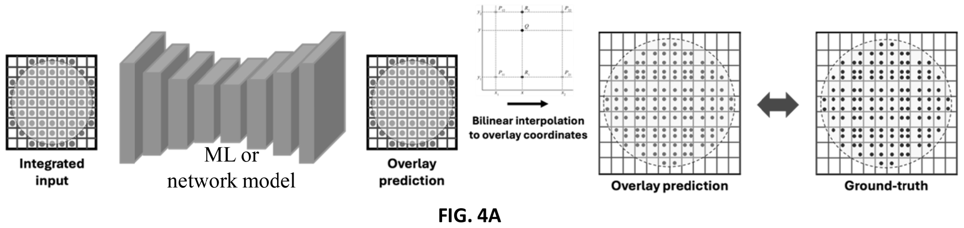

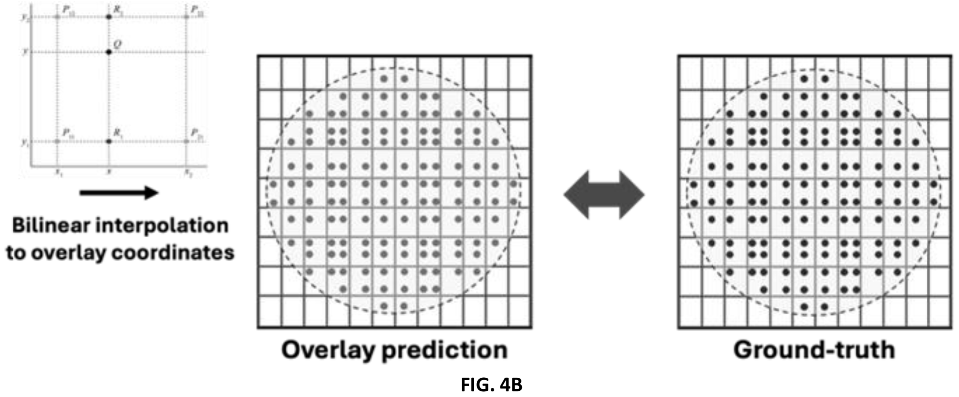

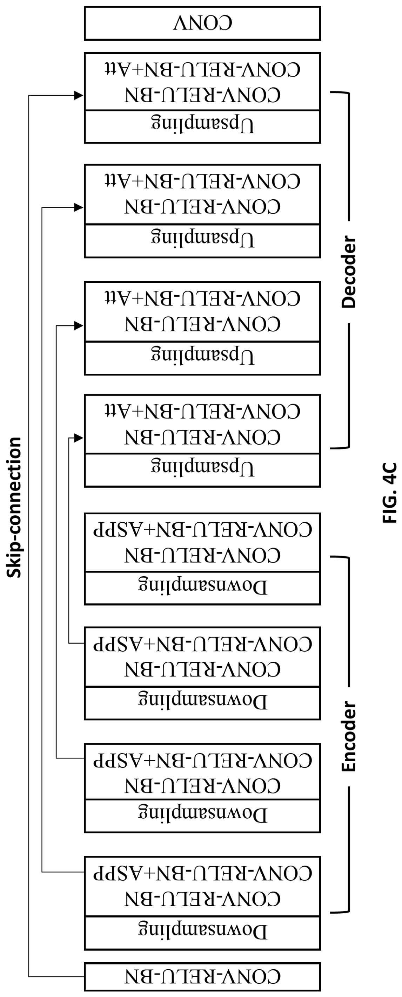

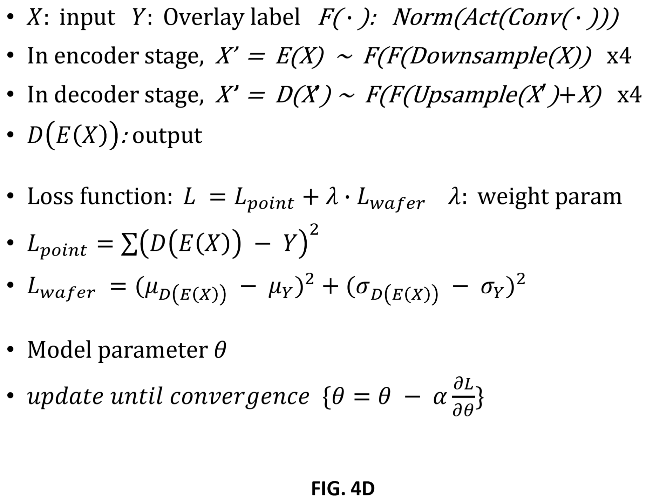

**FIGs. 4A-4D** depict an example spatial virtual metrology (VM) for predicting data (e.g., overlay measurements) at any coordinate of a wafer or an integrated grid, in accordance with some embodiments. **FIG. 4A** depicts the example method, which can include using an integrated grid as an input for training a machine learning (ML) model to predict an overlay of a wafer, e.g., a 300 millimeter (mm) by 300 mm wafer. **FIG. 4B** further depicts the example method, which can include using an estimation function (e.g., bilinear interpolation) to predict data at any coordinate of the wafer or the integrated grid and to compare the predicted overlay to an actual (e.g., measured) overlay. **FIG. 4C** further depicts the example method, which can include training and using a baseline convolutional neural network (CNN) with an encoder, decoder, and skip-connection to preserve the scale of the integrated grid. **FIG. 4D** further depicts the example method, which can include certain functions or formulas of the CNN for implementing the encoder, decoder, or skip-connection.

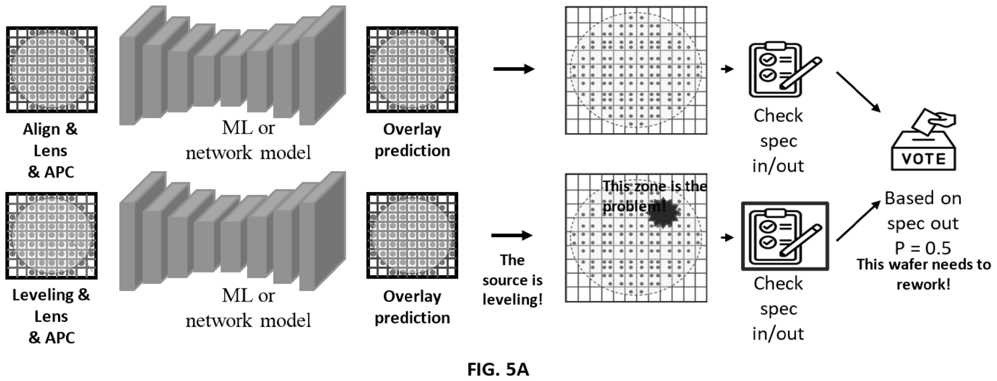

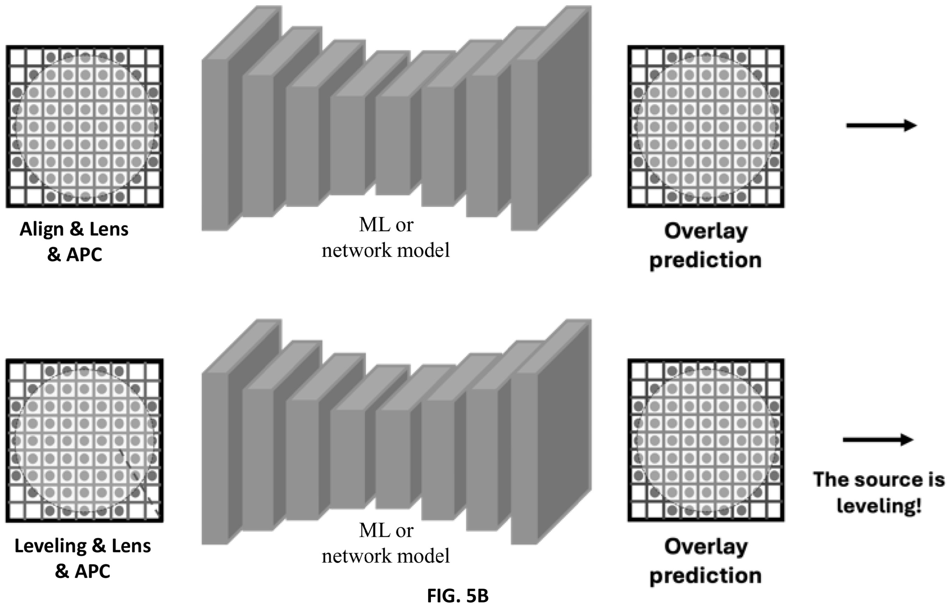

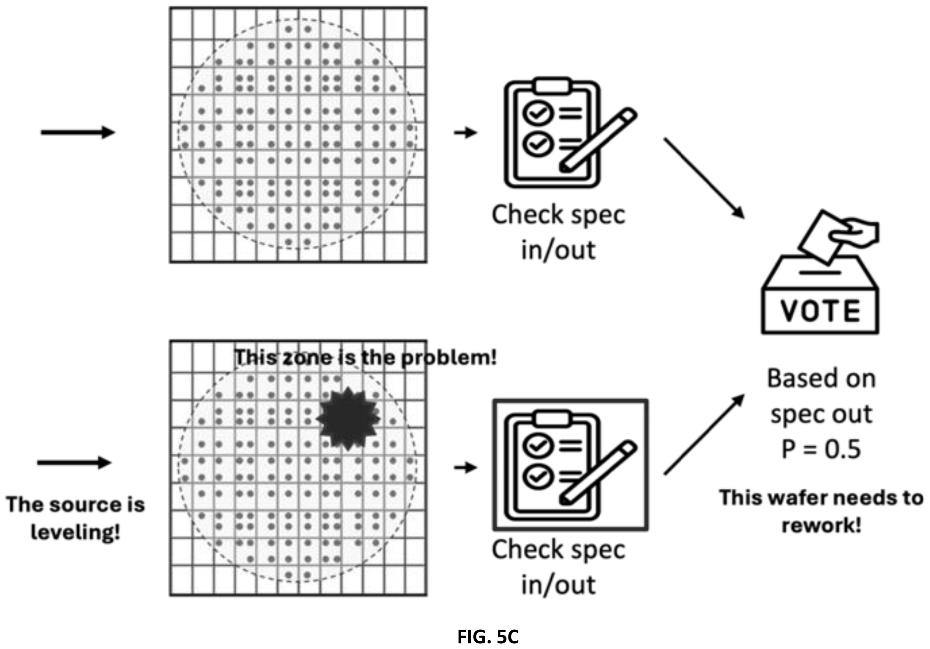

**FIGs. 5A-5C** depict an example spatial virtual metrology (VM) method for using a using a predicted overlay to detect an abnormal wafer, in accordance with some embodiments. **FIG. 5A** depicts the example method, which can include detecting the abnormal wafer by comparing the actual (e.g., measured) overlay of the wafer to the predicted overlay of the wafer. An abnormal wafer can be determined when the actual overlay is out of specification (or spec-out), e.g., when the mean and sigma deviate from the specification of a normally patterned wafer. **FIG. 5B** further depicts the example method, when can include using two predicted overlays, e.g., a predicted overlay from alignment data, lens data, and advanced process control (APC) data or a predicted overlay from leveling data, lens data, and APC data. **FIG. 5C** further depicts the example method, which can include using the predicted overlays to determine whether the actual overlays are out of specification. An abnormal wafer can be identified for rework.

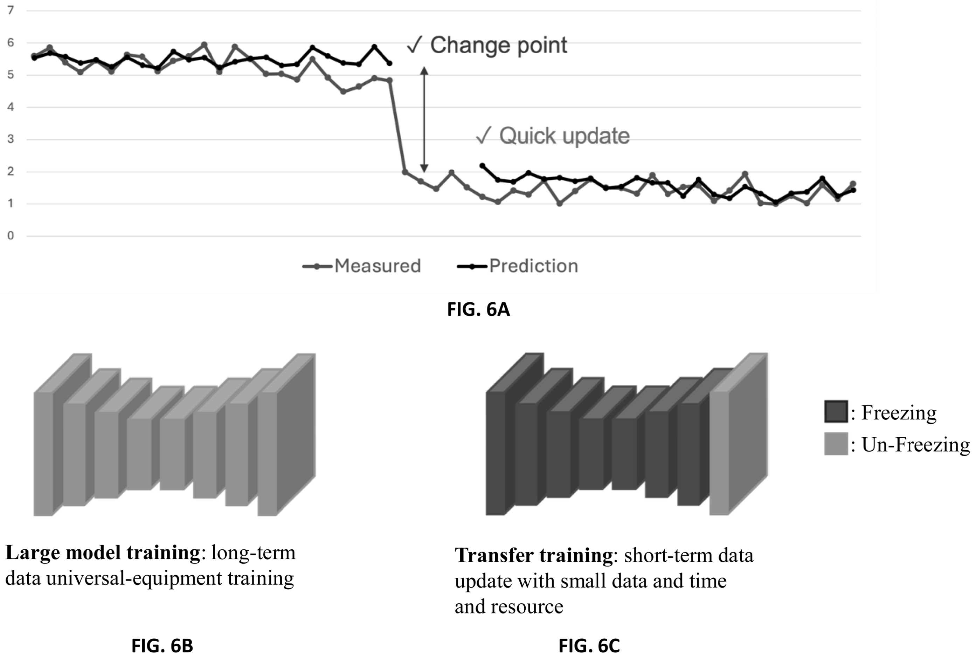

**FIGs. 6A-6C** depict an example spatial virtual metrology (VM) method for using transfer learning to update a machine learning (ML) model, in accordance with some embodiments. **FIG. 6A** illustrates an example mean graph of when an actual (e.g., measured) overlay may deviate in a statistically significant way at a time point or a time period due to changes in process equipment or processes caused by, e.g., preventive maintenance (PM). **FIG. 6B** further illustrates training the machine learning (ML) model with long-term data from process equipment or processes. **FIG. 6C** further illustrates using transfer learning to update a portion of the ML model with short-term data when the actual (e.g., measured) overlay deviates in a statistically significant way.

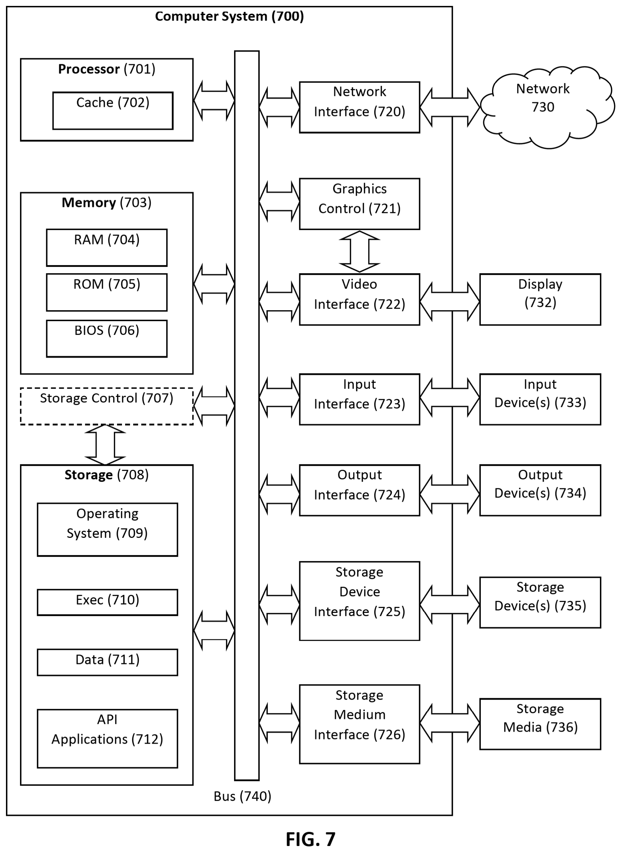

**FIG. 7** depicts a non-limiting example of a computing device configured to perform methods herein, in accordance with some embodiments.

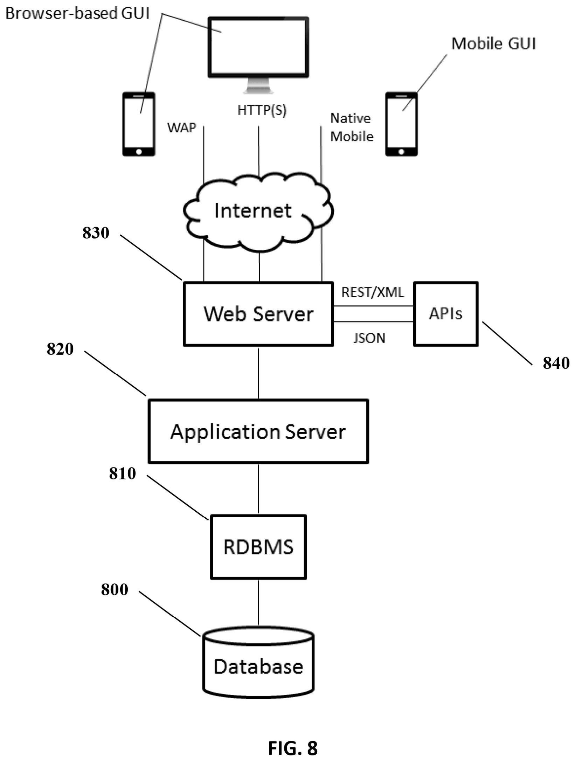

**FIG. 8** depicts a non-limiting example of a web/mobile application provision system configured to perform methods herein, in accordance with some embodiments.

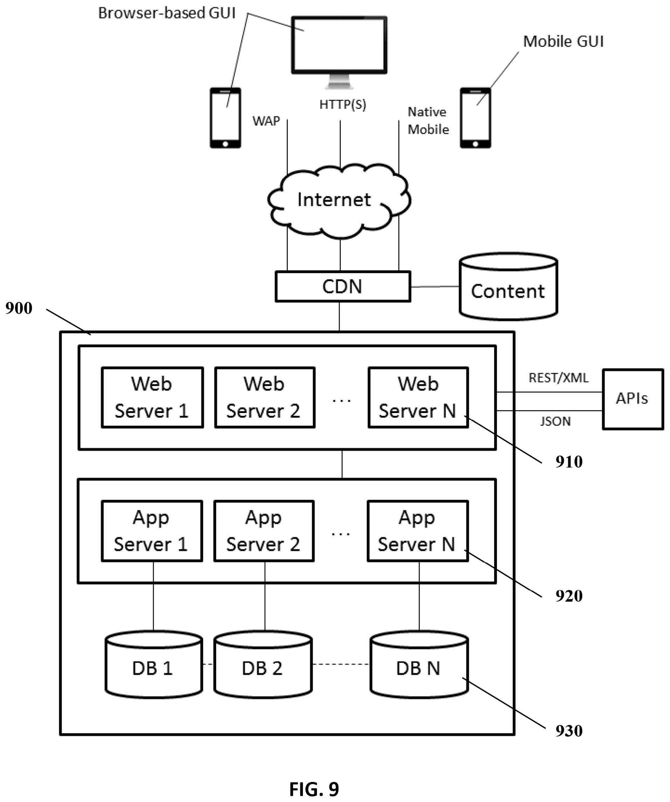

**FIG. 9** depicts a non-limiting example of a cloud-based web/mobile application provision system configured to perform methods herein, in accordance with some embodiments.

### DETAILED DESCRIPTION

While various embodiments of the present disclosure have been shown and described herein, such embodiments are provided by way of example only. Numerous variations, changes, or substitutions may occur without departing from the present disclosure. It should be understood that various alternatives to the embodiments of the present disclosure described herein may be employed.

### Overview

Typical systems and methods for determining or measuring an overlay of a patterned wafer are deficient. For example, typical systems and methods may only measure an overlay of a patterned wafer once in every twenty patterned wafers. Low sampling can allow wafers that are out of specification (or spec-out) to pass to the next process without rework thereby reducing yield during manufacturing. Also, such low sampling can require reworking the spec-out wafers thereby increasing costs during manufacturing. Further, each overlay can take about one minute to measure. Such time-consuming measurements can make sampling more patterned wafers impractical.

Further, typical systems and methods may use a conventional convolutional neural network (CNN) as a prediction function for an overlay of a patterned wafer. However, such methods cannot efficiently or effectively utilize spatial information from multimodal machine data. For example, such methods may only determine an overlay for fixed coordinates instead of any coordinate on a patterned wafer. Further, such methods cannot process different types of data that result from different process equipment or processes thereof. Moreover, such methods cannot identify or detect abnormal wafers from predicted overlays. Also, such methods cannot process data with data shift or data drift that can be present when process equipment undergoes maintenance or ages.

Recognized herein is a need for systems and methods that can provide technical solutions for solving technical challenges during metrology (e.g., predicting or measuring an overlay of a patterned wafer) thereby improving yield and lowering costs in semiconductor manufacturing. In some cases, systems and methods herein can be used to predict an overlay of an unmeasured, patterned wafer. Compared to other methods, predicted overlays can be used to virtually sample every patterned wafer thereby improving sampling, yield, and costs during semiconductor manufacturing. As but one example use case of the present disclosure, systems and methods herein can predict an overlay of an unmeasured, patterned wafer that results from using lithography equipment and processes thereof in semiconductor manufacturing.

For example, manufacturing a single wafer can involve multiple process equipment, processes, and measurements over a period of time. The lithography process can include using a mask (e.g., a photomask) to pattern a circuit on multiple layers or levels of a wafer. Specifically, a mask can be used to expose a part of the wafer with light. The exposed part of the wafer can remain or be removed by etching. In some embodiments, measurements of the overlay or the predicted overlay comprise a spatial difference or a displacement between layers of the patterned wafer. For example, during the process, a staggered difference or displacement of the overlay can result between the previously patterned structure or layer patterned below the current patterned structure or layer. The overlay can be measured by metrology equipment after each patterning process is performed for each layer. The overlay can be used to adjust lithography equipment parameters for the next wafer or detect a wafer for repairing or rework. As mentioned, an overlay may be measured for only a subset of patterned wafers due to costs and time. Compared to other methods, systems and methods herein can predict an overlay of every patterned wafer.

Briefly, to predict an overlay of a patterned wafer, systems and methods herein can include using gridization (or an integrated grid or equispatial grid), overlay-specific regression networks, transfer learning methods to deal with data shift or data drift, and abnormal wafer detection. In some cases, the integrated grid can include multimodal machine data or inputs, e.g., alignment data, leveling data, lens data, servo data, advanced processing control (APC) data, and fault detection and classification (FDC) data. while preserving a physical space or scale of patterned features of a wafer. Preserving the physical space or scale can enable using multimodal machine input data of diverse types to train the machine learning (ML) model. The APC data can be modeled from overlays of a previous lot of patterned wafers and used as an input feature to train the ML model to help model equipment-bias data. A scale of the integrated grid can be preserved during processing by the trained ML model. A final output of the trained ML model, e.g., a predicted overlay, can be compared with an actual (e.g., measured) overlay of the patterned wafer at any coordinate of the patterned wafer. For example, the predicted overlay can use an estimation function, e.g., bilinear interpolation, to predict a measurement anywhere on the patterned wafer. In some cases, the overlay-specific regression network can preserve a scale or size of features of the patterned wafer by extracting local-global features from input data to precisely predict an overlay of a patterned wafer. For example, local features can be extracted in a patch of an image of a patterned wafer, e.g., corners, blobs, or junctions, and used to describe image content around these local features. Global features can be used to determine whole image features of the patterned wafer. In some cases, transfer learning methods can respond quickly to abrupt changes or gradual changes in input data characteristics that can result from maintenance or aging of process equipment.

**FIGs. 1A-1C** depict an example architectures or pipelines configured to perform spatial virtual metrology (VM) methods for predicting an overlay of a wafer, in accordance with some embodiments. **FIG. 1A** depicts an example high-level architecture or pipeline, which can be configured to perform methods herein for determining VM values with high spatial density using multimodal machine data from processing equipment in manufacturing environments. Compared to other methods having overlays with low spatial density, an output of the pipeline can include a predicted overlay having VM values with high or higher spatial density. For example, a wafer can be patterned by process equipment and processes. The process equipment may have controls for adjusting parameters that in turn affect certain data or different types of data of the process equipment or processes. Data herein may be referred to as a multimodal machine data set (or machine data set).

In some embodiments, the machine data set is a multimodal data set comprising alignment data, leveling data, lens data, servo data, advanced process control (APC) data, or fault detection and classification (FDC) data. In some cases, the machine data set can be a measured data set of the process equipment or processes used during patterning a wafer. For example, alignment data can include data associated with alignment and can be measured by alignment or misalignment between a wafer and a mask by using a laser beam. In some cases, reference alignment data corresponding to the recent alignment trend may be calculated and subtracted from the alignment data to generate delta alignment data, which may be used as a substitute. Leveling data can include data associated with leveling and can be measured by a height from a reference point (e.g., zero points) using a laser beam. Lens data can include data associated with a lens and can be measured by aberrations of a lens and determined coefficients by decomposing aberration values with a Zernike polynomial. Servo data can include data associated with servos for aligning a photomask to a wafer in lithography processes. APC data refers to data used to monitor process conditions in real time and automatically adjust them, if necessary to increase quality and productivity during the process. APC data can be pre-calibrated before exposure in photolithography processes and obtained by using past overlay history. Fault detection and classification (FDC) data refers to sensor data, e.g., temperature and pressure, in a process, which can be important for detecting and classifying defects that may occur during a process to optimize quality control.

In some cases, as further depicted in **FIG. 1A****,** the pipeline may use metrology methods or VM methods to measure or determine an actual (e.g., measured) overlay of a patterned wafer. For example, the actual overlay can be used as in input feature to train the machine learning (ML) model herein for predicting an overlay of a patterned wafer. In some embodiments, measurements of the overlay or the predicted overlay comprise a critical dimension (CD) or a film thickness. For example, the predicted overlay can be a VM value at any location of the patterned wafer. In some cases, metrology measurements can include thickness, bow, thickness variation, flatness, line width, hole diameter, or thin film thickness.

**FIG. 1B** depicts an example low-level architecture or pipeline, which can be configured to perform methods herein for training a ML model to predict an overlay of a patterned wafer. For example, a wafer can be patterned by process equipment or processes. Multimodal machine data (as input data) and an overlay (as output data) can be received, determined, or measured after patterning the wafer. The multimodal machine data and the overlay can be provided to a datalake for use in training the ML model with long-term data. The input data can be correlated with the output data to train the ML model for predicting the overlay of a patterned wafer. The trained ML model and results can be saved in object storage for later use. The trained ML model can be loaded from object storage to perform inference in real time using real-time multimodal machine data. The real-time data can be passed to and processed by a distributed streaming platform, e.g., Apache^{®} Kafka, to develop a real-time trained ML model. The real-time trained ML model can perform inference modeling. The inference modeling can be used to model data or test real-time multimodal machine data. The inference modeling can be used to generate the predicted overlay and a summary of any rework due to spec-out wafers. The predicted overlay and results can be provided or displayed to a user via a user service application. The user service application can be configured as a graphical user interface (GUI) with operable graphical features. The GUI can be configured to allow the user to manipulate or otherwise interact with the predicted overlay or the results thereby allowing the user to adjust parameters of process equipment or processes to improve wafer yield.

**FIG. 1C** depicts example manufacturing environments that may be associated with semiconductor manufacturing environments having semiconductor manufacturing processes. Semiconductor manufacturing environments may be associated with semiconductor manufacturing equipment (e.g., process equipment) configured to carry out semiconductor manufacturing processes. Systems and methods herein can predict an overlay of a patterned wafer resulting from the process equipment and processes. In some embodiments, the process of the machine comprises a lithography process, an etching process, or a thin film process. Processes can include wafer fabrication processes, e.g., ingot pulling, ingot slicing, wafer grinding, or oxidation. Processes can include mask fabrication processes, e.g., circuit design, pattern design, or photo masking. Processes can include front-end processes, e.g., pattern lithography, etching, chemical vapor deposition (e.g., ion implantation, oxidation, diffusion), photoresist coating, or planarization. Processes can include intermediate inspections e.g., inspection of wafers. Processes can include back-end processes, e.g., wafer dicing, chip mounting, wire bonding, molding, trimming, or forming. Processes can include intermediate testing, e.g., burn-in temperature or voltage testing. Processes can include final inspection or reliability testing. Processes can include marking.

In some cases, a machine leaning (ML) model may be referred to as a neural network model or a network model.

### Methods for predicting an overlay of a wafer patterned by processing equipment

In an aspect, disclosed herein is a method for predicting an overlay of a wafer. In some embodiments, the method comprises (a) receiving a machine data set comprising parameters at a plurality of positions of a wafer. In some embodiments, the wafer is to be patterned by a machine to yield a patterned wafer. In some embodiments, the method comprises (b) generating an integrated data set by (i) aggregating the parameters and (ii) mapping the aggregated parameters to an equispatial grid. In some embodiments, the method comprises (c) generating, using a trained machine learning (ML) model, a predicted overlay for the patterned wafer based at least in part on processing the integrated data set. In some embodiments, the method comprises (d) inferring a statistical deviation of the predicted overlay from a normally patterned wafer. In some cases, the method comprises training the ML model using a machine data set comprising parameters from a single machine used to pattern the wafer. In some cases, the method comprises training the ML model using one or more overlays comprising measurements from a single machine used to pattern the wafer.

Typical systems and methods may inefficiently integrate input data (e.g., machine data or overlays) in series instead of advantageously processing multiple input data in parallel using gridization as described herein. Processing multiple input data can preserve and exploit spatial information of each input data. By using an appropriate estimation function, vacant grids of the gridization can be filled with estimated values using interpolation.

For example, **FIGs. 2A-2D** depict an example spatial virtual metrology (VM) method for predicting an overlay of a patterned wafer, in accordance with some embodiments. **FIG. 2A** depicts the example method, which can include using multimodal machine data to generate an integrated grid (or an equispatial grid) for training a ML model to predict an overlay of a patterned wafer, e.g., a 300 millimeter (mm) by 300 mm wafer. In some embodiments, the machine data set is a multimodal data set comprising alignment data, leveling data, lens data, servo data, advanced process control (APC) data, or fault detection and classification (FDC) data. As described herein, leveling data can include data associated with leveling and can be measured by a height from a reference point (e.g., zero points) using a laser beam. Lens data can include data associated with a lens and can be measured by aberrations of a lens and determined coefficients by decomposing aberrations values with a Zernike polynomial. Servo data can include data associated with servos for aligning a photomask to a wafer in photolithography processes. Data from APC can include data associated with temperature measurements, pressure measurements, flow rates, feedstock composition, product quality attributes (e.g., viscosity or density), energy consumption, reaction rates, mixing times, and other relevant process variables that can be monitored in real-time during semiconductor manufacturing.

**FIG. 2B** further depicts the example method, which can include overlaying a wafer with the integrated grid. In some embodiments, the plurality of positions of the machine data set comprises positions across the patterned wafer that are random, uniformly distributed, or nonuniformly distributed. For example, compared to other methods, output overlays can be predicted everywhere on a patterned wafer instead of at pre-defined or fixed positions of the patterned wafer. Also, machine data may not be measured at equal intervals across a wafer but rather at irregular coordinates. Methods herein can transform all measurements into an integrated grid with an equal interval.

**FIG. 2C** further depicts the example method, which can include using alignment data, leveling data, or lens data to generate a plurality of integrated grids for use as input features to train the ML model. For example, considering physical space, methods herein can initially generate a fixed grid. The fixed grid can be filled using an interpolation method thereby yielding an integrated grid with a flexible coordinate system. Multiple integrated grids can be generated in this way with an integrated grid for each of the alignment data, leveling data, or lens data. Methods herein can aggregate the multiple integrated grids for use as input features for training the machine (ML) model. Aggregating the multiple integrated grids can be useful for easily removing or adding features before training the ML model. Also, aggregating the multiple integrated grids can be useful for training the machine (ML) model as a universal model. For example, using a universal model can reduce model computing resources and increase model computing performance by universally training on different types of process equipment or processes. Also, using a universal model can reduce technical challenges associated with training a ML model with scarce or sparse data because the integrated data set can include more data for training in an efficient way.

**FIG. 2D** further depicts the example method, which can include outputting the predicted overlay as a flexible overlay for predicting data (e.g., overlay measurements) at any coordinate of the patterned wafer or the integrated grid. In some embodiments, the plurality of other positions of the predicted overlay comprises positions across the patterned wafer that are random, uniformly distributed, or nonuniformly distributed. For example, compared to other methods where a number of the overlays or coordinates thereof may be fixed, methods herein can generate a flexible, predicted overlay to predict a measurement at any coordinate of the patterned wafer.

In some embodiments, the trained ML model is trained using at least one or more of (i) the equispatial grid, (ii) the integrated data set, or (iii) a measured overlay of the patterned wafer. In some embodiments, the method further comprises repeating (a) - (d) until all layers of the wafer are patterned by the machine.

In some embodiments, the method further comprises training the ML model using one or more machine data sets comprising parameters from two or more machines used to pattern the wafer. In some embodiments, the method further comprises training the ML model using one or more overlays comprising measurements from two or more machines used to pattern the wafer. For example, different data from different types of process equipment or processes can be aggregated as an integrated data set to training the ML model.

Typical systems and methods may only predict an overlay from a single process equipment or process with a single model. Systems and methods herein can universally train and test data from diverse process equipment and processes using the integrated grid herein. Doing so can advantageously train ML models to handle multiple types of process equipment or processes. In some cases, methods for predicting an overlay for diverse process equipment and processes can be the same or similar as methods for predicting an overlay for a single process equipment or process as illustrated in **FIG. 2A-2D****.**

For example, **FIGs. 3A-3D** depict an example spatial virtual metrology (VM) method for predicting an overlay of a wafer, in accordance with some embodiments. **FIG. 3A** depicts the example method, which can include using multimodal machine data to generate an integrated grid (or an equispatial grid) for training a ML model to predict an overlay of a wafer, e.g., a 300 millimeter (mm) by 300 mm wafer. In some embodiments, the machine data set is a multimodal data set comprising alignment data, leveling data, lens data, servo data, advanced process control (APC) data, or fault detection and classification (FDC) data. For example, alignment data may be used from multiple process equipment (e.g., equipment A, B, and C). **FIG. 3B** further depicts the example method, which can include overlaying a wafer with the integrated grid. In some embodiments, the plurality of positions of the machine data set comprises positions across the patterned wafer that are random, uniformly distributed, or nonuniformly distributed. For example, compared to other methods, output overlays can be predicted everywhere on a wafer instead of at pre-defined or fixed positions. Also, machine data may not be measured at equal intervals across a wafer but rather at irregular coordinates. Methods herein can transform all measurements into an integrated grid with an equal interval. **FIG. 3C** further depicts the example method, which can include using alignment data from a plurality of processing equipment (e.g., equipment A, B, and C) or processes, leveling data from a plurality of processing equipment or processes, or lens data from a plurality of processing equipment or processes. The data can be used to generate a plurality of integrated grids for use as input features to train the ML model. **FIG. 3D** further depicts the example method, which can include outputting the predicted overlay as a flexible overlay for predicting data (e.g., overlay measurements) at any coordinate of the wafer or the integrated grid.

In some embodiments, the trained ML model is trained using at least one or more of (i) the equispatial grid, (ii) the integrated data set, or (iii) a measured overlay of the patterned wafer. In some embodiments, the method further comprises repeating (a) - (d) until all layers of the patterned wafer are patterned by the machine.

### Methods for developing a deep neural network to generate a predicted overlay

In some embodiments, the trained ML model is a deep neural network. In some embodiments, the deep neural network comprises an encoder layer configured to obtain (i) global context features of the patterned wafer and (ii) intra-input feature correlation. In some embodiments, the deep neural network comprises a decoder layer configured to determine the global context features of the patterned wafer. In some embodiments, the deep neural network comprises a skip connection layer configured to use at least local context features and the intra-input feature correlation to generate the predicted overlay.

For example, **FIGs. 4A-4D** depict an example spatial virtual metrology (VM) method for predicting data (e.g., overlay measurements) at any coordinate of a wafer or an integrated grid, in accordance with some embodiments. **FIG. 4A** depicts the example method, which can include using an integrated grid as an input for training a machine learning (ML) model to predict an overlay of a wafer, e.g., a 300 millimeter (mm) by 300 mm wafer. For example, methods herein can use the integrated grid to train the ML model, predict an intermediate overlay for the patterned wafer, use an estimation function for determining measurements at other coordinates of the integrated grid, generate the final predicted overlay, and compare the predicted overlay to a ground truth, e.g., a normally patterned wafer.

**FIG. 4B** further depicts the example method, which can include using the estimation function (e.g., bilinear interpolation) to predict data (e.g., measurements) at any coordinate of the patterned wafer or the integrated grid and to compare the predicted overlay to an actual (e.g., measured) overlay. As mentioned, the integrated grid can be used to train the machine learning (ML) model and to output the predicted overlay of a patterned wafer. In some embodiments, the method further comprises applying an estimation function to the predicted overlay to predict a measurement at a plurality of other positions different than the plurality of positions of the predicted overlay. For example, methods herein can use bilinear interpolation to determine or predict measurements at any coordinate of the patterned wafer. In some cases, the coordinates may be the same as the coordinates of the integrated grid. In some cases, the coordinates may different than the coordinates of the integrated grid. Using an estimation function, measurements at coordinates interior to the integrated grid can be determined or predicted. In some cases, the coordinates may overlap with (e.g., a subset) with the coordinates of the integrated grid.

**FIG. 4C** further depicts the example method, which can include training and using a baseline convolutional neural network (CNN) with an encoder, decoder, and skip-connection to preserve the scale of the integrated grid. In some embodiments, the trained ML model is configured to preserve a spatial scale of any feature of the predicted overlay. For example, an initial scheme can be baselined from a typical U-Net. The U-Net can be modified to preserve a scale of the integrated grid and to use an encoder-decoder structure. In some cases, the encoder can be configured to use nine layers and down sample by one-sixteenth. In some cases, the encoder can be configured to obtain global context features and intra-input feature correlation. In some cases, the encoder can be configured as an atrous spatial pyramid pooling (ASPP) module. The ASPP module can incorporate various dilation kernels to obtain diverse global context scales such as various scale input feature patterns.

In some cases, the decoder stage can be configured to decode global context from encoded features. In some cases, local context can be loaded from the skip-connection layer to predict an overlay of a patterned wafer. In some cases, methods herein can use an attention module. For example, the attention module can be configured to focus on important features or areas or the most important features or areas in the encoded features related to the predicted overlay. In some cases, methods herein may use a weight decay of 0.0005, a momentum of 0.9, and adopt the weight initialization. In some cases, methods herein may train the ML model by initializing the training with a minibatch size of 16 and a learning rate of 0.0005 for 100 epochs.

In some cases, the network may be transformed in a number of ways. A few examples of network transformations can include changing down-sampling rates, adjusting the number of encoder and decoder layers, varying the number of channels in each layer, and the like. In some cases, different modified networks can extract complementary features from distinct contexts. In some cases, transformed networks of diverse architectures may be combined in parallel. In some cases, transformed networks of diverse architectures may be combined in series. In some cases, transformed networks of diverse architectures may be combined in parallel and in series. In some cases, combining transformed networks can provide particular advantage and utility compared over performing a task with a single network.

**FIG. 4D** further depicts the example method, which can include certain functions or formulas of the CNN for implementing the encoder, decoder, or skip-connection. For example, X can be defined as an input and Y can be defined as an output. A convolution block F can include a convolution layer, an activation function, and a normalization layer. The encoder E can include a four encoder block configured with a down sampling layer and two convolution blocks F. In some cases, the configurations of the encoder E, the decoder D, and the convolution blocks F can be transformed to construct diverse networks. For example, the convolution block F may be combined in various orders. In another example, the convolution blocks F can include convolution layers of different sizes, along with activation functions such as rectified linear unit (ReLU) and sigmoid, as well as normalization layers such as batchnorm (BN) and layernorm (LN). The decoder D can include a four decoder block configured with an up sampling layer and two convolution blocks F. During training, the backpropagation with loss function can be performed for the training model. The loss function can include point-wise loss, Lₚₒᵢₙₜ, and wafer-wise loss, L_{wafer}. The first loss can include a mean square error (MSE) loss for point-wise overlay. The MSE loss can be adopted rather than a mean absolute error (MAE) loss to catch high-frequency overlay values. The second loss can include MSE loss for wafer-wise mean and sigma of overlay. The loss may be introduced to induce the model to follow the distribution of the entire wafer globally. The second loss can be weighted lower than the first loss along the way through λ because the point-wise loss can be more important than the wafer-wise loss. The gradient descent can be performed to train model parameters θ with a loss function. The model parameters can be updated until convergence to predict a better overlay.

### Methods of using transfer learning to generate a predicted overlay

In some embodiments, the method further comprises using the predicted overlay to predict a drift or a shift in the machine or processes of the machine. In some embodiments, the method further comprises using transfer learning to update a portion of the trained ML model before patterning a subsequent wafer. In some embodiments, the transfer learning is based at least on analyzing recent trends between the machine data set and the measured overlay.

Compared to typical systems and methods, systems and methods herein can operate in view of data shift and data drift. Data shift can result from changes in process equipment caused by, e.g., preventive maintenance (PM). Data drift can result from aging of process equipment. Data shift and data drift can cause abrupt changes or gradual changes in the characteristics between machine data and overlays. Methods herein can use transfer learning to follow the changed trend of data. For example, the trained ML model can be trained by data without data shift or data drift. If data shift or data drift is present, a portion of the trained ML model can be retrained with post-shift data or post-drift data. In this way, the updated ML model can predict or follow the changed characteristics in a short time.

For example, **FIGs. 6A-6C** depict an example spatial virtual metrology (VM) method for using transfer learning to update a machine learning (ML) model, in accordance with some embodiments. **FIG. 6A** illustrates an example mean graph of when an actual (e.g., measured) overlay may deviate in a statistically significant way at a time point or a time period due to changes in process equipment or processes caused by, e.g., preventive maintenance (PM). For example, maintenance of process equipment can cause the distribution of a predicted overlay or an actual overlay to shift in a statistically significant way. Methods herein can predict or follow the changed distribution quickly using transfer learning to update a portion of the trained ML model. In some cases, the input data may not change after preventive maintenance. Accordingly, the input-output data pair may need to be retrained with a few data points (e.g., short-term data) to reduce training time compared to training the ML model with all data, e.g., short-term data and long-term data.

**FIG. 6B** further illustrates training the ML model with long-term data from process equipment or processes. For example, the trained ML model may normally trained with long-term data. However, this can result in inaccurate predictions, e.g., an inaccurate predicted overlay. **FIG. 6C** further illustrates using transfer learning to update a portion of the ML model with short-term data when the actual overlay deviates in a statistically significant way. For example, a portion of the trained ML model can be updated using transfer learning with short-term data. Because only a portion of the trained ML model is updated with a few data points (e.g., layers at the backend of the trained ML model, the training time can be very short, e.g., a few minutes. The transfer learning can maintain as much long-term data as needed and learn the bias of the changed data to predict a more accurate predicted overlay in view of the changed distribution.

### Methods of using predicted overlays

### Advanced process control (APC)

**In** some embodiments, the predicted overlay is operable for performing advanced process control (APC). In some embodiments, the method comprises using the predicted overlay to determine parameters of the APC. In some embodiments, the method comprises adjusting parameters of the machine in real time based at least on using the determined parameters. In some embodiments, the adjusted parameters improve a yield of subsequent wafers to be patterned by the machine by at least 1%. In some embodiments, the method further comprises using the predicted overlay to adjust parameters of the machine before patterning a subsequent wafer by the machine.

For example, systems and methods herein can use the predicted overlay to replace or enhance virtual metrology (VM) or real metrology. As mentioned, actual (e.g., measured) overlays may be infrequently sampled due to cost and time. Systems and methods herein can continuously monitor overlays, e.g., predict an overlay for every wafer, in order to contribute to or augment APC. For example, APC can help ensure that wafer exposure is accurately performed by adjusting process equipment parameters. In some cases, APC can be determined from the previous predicted overlay to adjust APC in a faster cycle or in real time. Example improvements can include at least improving wafer quality and wafer yield.

### Abnormal wafer detection

**In** some embodiments, the method further comprises using the predicted overlay to predict an anomaly in the patterned wafer. In some embodiments, the method further comprises re-patterning the patterned wafer when the statistical deviation is determined to be outside a prescribed threshold. In some embodiments, the method further comprises adjusting a density of the equispatial grid based at least on user-defined criteria or the statistical deviation.

Systems and methods herein can detect abnormal wafers using predicted overlays. An abnormal wafer can be defined as one that deviates from the mean and sigma of a normally patterned wafer. In some cases, methods herein can predict point-wise overlays and determine whether the mean and sigma of the overlays are out of specification (or spec-out). A spec-out wafer can be sent for rework. For example, the loss for the detection can be added to point-wise overlay mean square error (MSE) loss for determining an intra-overlay distribution. Accordingly, methods herein can show all coordinate points of an overlay and zone related to the abnormal wafer.

For example, **FIGs. 5A-5C** depict an example spatial virtual metrology (VM) method for using a predicted overlay to detect an abnormal wafer, in accordance with some embodiments. In some embodiments, the method further comprises, before patterning a subsequent wafer, using the predicted overlay to adjust (i) one or more parameters of the machine or (ii) one or more process parameters of the machine. For example, systems and methods herein can use the predicted overlay to identify patterned wafers that are out of specification (or spec-out) and send wafers to rework. Compared to other methods when the actual overlay is not measured, the patterned wafer that needs to be reworked moves on to the next process without the rework process. In contrast, systems and methods herein can identify or detect the patterned wafer that needs to be reworked even when the actual overlay is not measured. Example improvements can include at least reducing the cost and process time by preventing any process problems in advance.

**FIG. 5A** depicts the example method, which can include detecting the abnormal wafer by comparing the actual overlay of the wafer to the predicted overlay of the wafer using a statistical deviation. In some embodiments, the statistical deviation comprises a mean deviation or a sigma deviation. For example, an abnormal wafer can be determined when the actual overlay is or spec-out, e.g., when the mean and sigma deviate from the specification. For example, methods herein can be used to predict or detect an abnormally patterned wafer. During processing of a wafer, the patterned wafer may be determined to be spec-out and need rework. A spec-out patterned wafer may be compared to a normally patterned wafer to determine whether the patterned wafer has a mean and sigma that deviates from a pre-defined specification. In some cases, methods herein can determine or predict whether the patterned wafer is abnormal when the overlay is measured after processing the wafer.

**FIG. 5B** further depicts the example method, when can include using two predicted overlays, e.g., a predicted overlay from alignment data, lens data, and advanced process control (APC) data or a predicted overlay from leveling data, lens data, and APC data. For example, in some cases, alignment and leveling feature characteristics can be used individually for detecting abnormal wafers. In this case, the two machine learning (ML) models can each be used to predict an overlay of the patterned wafer. The two predicted overlays can be analyzed to determine whether the actual overlays will be spec-out. If either of the actual overlays is determined to be spec-out, the patterned wafer may be abnormal and sent for rework. In some cases, methods herein can use related zone or overlay values to determine whether rework of the patterned wafer may be needed. In some cases, methods herein can provide explainable abnormal detection results.

**FIG. 5C** further depicts the example method, which can include using the predicted overlay to determine whether an actual overlay is spec-out. In such cases, an abnormally patterned wafer can be identified for rework.

In some embodiments, the predicted overlay is operable for performing virtual metrology (VM), root cause analysis (RCA), or image metrology (IM). For example, VM can refer to methods to predict properties of a wafer based on machine parameters and sensor data in the process equipment, without performing costly physical measurements of wafer properties. Statistical methods such as classification and regression can be used to perform VM. Depending on the accuracy of virtual data, it can be used in modelling for other purposes, such as predicting yield, preventative analysis, and the like. Virtual data can be useful for modelling techniques that are adversely affected by missing data. Root cause analysis can refer to methods to identify the underlying causes of defects or failures in a production process. Root cause analysis methods can go beyond just treating symptoms to find the fundamental reasons behind a problem and implement lasting solutions to prevent recurrence. Image metrology can refer to methods to optimize conventional metrology by generating more measurement information on the same image of a wafer. The ability to sample the entire product space after each process step can allow for highly rigorous process control or monitoring optimization resulting in variability reduction, yield optimization, reduction in lost revenue due to scrap (e.g., inoperable products), equipment downtime, and measurement costs.

### Methods generally for training machine learning models

Many machine learning (ML) methods implemented as algorithms are suitable as approaches to perform the methods described herein. Such methods include but are not limited to supervised learning approaches, unsupervised learning approaches, semi-supervised approaches, or any combination thereof.

Machine learning algorithms may include without limitation neural networks (e.g., artificial neural networks (ANN), multi-layer perceptrons (MLP), long short-term memory (LSTM)), support vector machines, k-nearest neighbors, Gaussian mixture model, Gaussian process, naive Bayes, decision trees, random forest, or gradient boosting trees. Linear machine learning algorithms may include without limitation linear regression with or without regularizer, logistic regression, naive Bayes classifier, perceptron, or support vector machines (SVMs). Other machine learning algorithms for use with methods according to the present disclosure may include without limitation quadratic classifiers, k-nearest neighbor, boosting, decision trees, random forests, neural networks, pattern recognition, Bayesian networks, or Hidden Markov models. Other machine learning algorithms, including improvements or combinations of any of these, commonly used for machine learning, can also be suitable for use with the methods described herein. Any use of a machine learning algorithm in a workflow can also be suitable for use with the methods described herein. The workflow can include, for example, cross-validation, nested-cross-validation, feature selection, row compression, data transformation, binning, normalization, standardization, and algorithm selection.

A machine learning algorithm can generally be trained by the following methodology to build a machine learning model. In some cases, generated models may determine or predict an overlay of a patterned wafer. Input data can include, for example, an integrated data set described herein. Output data can include, for example, a predicted overlay of a patterned wafer described herein.
1. Gather a dataset for "training" and "testing" the machine learning algorithm. The dataset can include many features, for example, features associated with alignment data, leveling data, lens data, servo data, or advanced process control (APC) data. The training dataset is used to "train" the machine learning algorithm. The testing dataset is used to "test" the machine learning algorithm.
2. Determine "features" for the machine learning algorithm to use for training and testing. The accuracy of the machine learning algorithm may depend on how the features are represented. For example, feature values may be transformed using one-hot encoding, binning, standardization, or normalization. Also, not all features in the dataset may be used to train and test the machine learning algorithm. Selection of features may depend on, for example, available computing resources and time or importance of features discovered during iterative testing and training. For example, it may be discovered that features associated with alignment data and leveling data are useful for predicting the overlay of the patterned wafer.
3. Choose an appropriate machine learning algorithm. For example, a machine learning algorithm described herein may be chosen. The chosen machine learning algorithm may depend on, for example, available computing resources and time or whether the prediction is continuous or categorical in nature. The machine learning algorithm is used to build the machine learning model.
4. Build the machine learning model. The machine learning algorithm is run on the gathered training dataset. Parameters of the machine learning algorithm may be adjusted by optimizing performance on the training dataset or via cross-validation datasets. After parameter adjustment and learning, the performance of the machine learning algorithm may be validated on a dataset of naive samples that are separate from the training dataset and testing dataset. The built machine learning model can involve feature coefficients, importance measures, or weightings assigned to individual features.

Once the machine learning model is determined as described above ("trained"), it can be used to predict an overlay of a patterned wafer.

### Examples

While various examples of the present disclosure have been shown and described herein, such examples are provided by way of example only. Numerous variations, changes, or substitutions may occur without departing from the present disclosure. It should be understood that various alternatives to the examples described herein may be employed.

### Example 1 - Performance of methods herein

Systems and methods herein were validated by applying the methods to different process equipment and processes thereof. For example, the pipeline of **FIG. 1B** was used to get a machine data set from process equipment or processes to predict an overlay of a patterned wafer and provide the predicted overlay to users. Table 1 depicts verification of the predicted overlay using R-squared (R²) as a measure of performance. The determined R² values demonstrate that the predicted overlay accurately predicts an actual (e.g., measured) overlay of a patterned wafer.

**Table 1**

| **Process** | **Equipment** | **R² (X)** | **R² (Y)** |
|---|---|---|---|
| 001 | B | 0.909 | 0.768 |
| | D | 0.942 | 0.859 |
| | F | 0.923 | 0.839 |
| 002 | A | 0.963 | 0.932 |
| | C | 0.961 | 0.948 |
| | E | 0.949 | 0.937 |
| | F | 0.956 | 0.930 |
| | G | 0.961 | 0.976 |
| 003 | B | 0.795 | 0.774 |
| | D | 0.860 | 0.761 |
| | F | 0.869 | 0.754 |

### Computing systems

In another aspect, disclosed herein is a system for predicting an overlay of a wafer comprising at least one processor and instructions executable by the at least one processor to cause the at least one processor to perform operations comprising: (a) receiving a machine data set comprising parameters at a plurality of positions of a wafer, wherein the wafer is to be patterned by a machine to yield a patterned wafer; (b) generating an integrated data set by (i) aggregating the parameters and (ii) mapping the aggregated parameters to an equispatial grid; (c) generating, using a trained machine learning (ML) model, a predicted overlay for the patterned wafer based at least in part on processing the integrated data set; and (d) inferring a statistical deviation of the predicted overlay from a normally patterned wafer.

Referring to **FIG. 7****,** a block diagram is shown depicting an exemplary machine that includes a computer system 700 (e.g., a processing or computing system) within which a set of instructions can execute for causing a device to perform or execute any one or more of the aspects and/or methodologies for static code scheduling of the present disclosure. The components in **FIG. 7** are examples only and do not limit the scope of use or functionality of any hardware, software, embedded logic component, or a combination of two or more such components implementing particular embodiments.

Computer system 700 may include one or more processors 701, a memory 703, and a storage 708 that communicate with each other, and with other components, via a bus 740. The bus 740 may also link a display 732, one or more input devices 733 (which may, for example, include a keypad, a keyboard, a mouse, a stylus, etc.), one or more output devices 734, one or more storage devices 735, and various tangible storage media 736. All of these elements may interface directly or via one or more interfaces or adaptors to the bus 740. For instance, the various tangible storage media 736 can interface with the bus 740 via storage medium interface 726. Computer system 700 may have any suitable physical form, including but not limited to one or more integrated circuits (ICs), printed circuit boards (PCBs), mobile handheld devices (such as mobile telephones or PDAs), laptop or notebook computers, distributed computer systems, computing grids, or servers.

Computer system 700 includes one or more processor(s) 701 (e.g., central processing units (CPUs) or general purpose graphics processing units (GPGPUs)) that carry out functions. Processor(s) 701 optionally contains a cache memory unit 702 for temporary local storage of instructions, data, or computer addresses. Processor(s) 701 are configured to assist in execution of computer readable instructions. Computer system 700 may provide functionality for the components depicted in **FIG. 7** as a result of the processor(s) 701 executing non-transitory, processor-executable instructions embodied in one or more tangible computer-readable storage media, such as memory 703, storage 708, storage devices 735, and/or storage medium 736. The computer-readable media may store software that implements particular embodiments, and processor(s) 701 may execute the software. Memory 703 may read the software from one or more other computer-readable media (such as mass storage device(s) 735, 736) or from one or more other sources through a suitable interface, such as network interface 720. The software may cause processor(s) 701 to carry out one or more processes or one or more steps of one or more processes described or illustrated herein. Carrying out such processes or steps may include defining data structures stored in memory 703 and modifying the data structures as directed by the software.

The memory 703 may include various components (e.g., machine readable media) including, but not limited to, a random access memory component (e.g., RAM 704) (e.g., static RAM (SRAM), dynamic RAM (DRAM), ferroelectric random access memory (FRAM), phase-change random access memory (PRAM), etc.), a read-only memory component (e.g., ROM 705), and any combinations thereof. ROM 705 may act to communicate data and instructions unidirectionally to processor(s) 701, and RAM 704 may act to communicate data and instructions bidirectionally with processor(s) 701. ROM 705 and RAM 704 may include any suitable tangible computer-readable media described below. In one example, a basic input/output system 706 (BIOS), including basic routines that help to transfer information between elements within computer system 700, such as during start-up, may be stored in the memory 703.

Fixed storage 708 is connected bidirectionally to processor(s) 701, optionally through storage control unit 707. Fixed storage 708 provides additional data storage capacity and may also include any suitable tangible computer-readable media described herein. Storage 708 may be used to store operating system 709, executable(s) 710, data 711, applications 712 (application programs), and the like. Storage 708 can also include an optical disk drive, a solid-state memory device (e.g., flash-based systems), or a combination of any of the above. Information in storage 708 may, in appropriate cases, be incorporated as virtual memory in memory 703.

In one example, storage device(s) 735 may be removably interfaced with computer system 700 (e.g., via an external port connector (not shown)) via a storage device interface 725. Particularly, storage device(s) 735 and an associated machine-readable medium may provide nonvolatile and/or volatile storage of machine-readable instructions, data structures, program modules, and/or other data for the computer system 700. In one example, software may reside, completely or partially, within a machine-readable medium on storage device(s) 735. In another example, software may reside, completely or partially, within processor(s) 701.

Bus 740 connects a wide variety of subsystems. Herein, reference to a bus may encompass one or more digital signal lines serving a common function, where appropriate. Bus 740 may be any of several types of bus structures including, but not limited to, a memory bus, a memory controller, a peripheral bus, a local bus, and any combinations thereof, using any of a variety of bus architectures. As an example and not by way of limitation, such architectures include an Industry Standard Architecture (ISA) bus, an Enhanced ISA (EISA) bus, a Micro Channel Architecture (MCA) bus, a Video Electronics Standards Association local bus (VLB), a Peripheral Component Interconnect (PCI) bus, a PCI-Express (PCI-X) bus, an Accelerated Graphics Port (AGP) bus, HyperTransport (HTX) bus, serial advanced technology attachment (SATA) bus, and any combinations thereof.

Computer system 700 may also include an input device 733. In one example, a user of computer system 700 may enter commands and/or other information into computer system 700 via input device(s) 733. Examples of an input device(s) 733 include, but are not limited to, an alphanumeric input device (e.g., a keyboard), a pointing device (e.g., a mouse or touchpad), a touchpad, a touch screen, a multi-touch screen, a joystick, a stylus, a gamepad, an audio input device (e.g., a microphone, a voice response system, etc.), an optical scanner, a video or still image capture device (e.g., a camera), and any combinations thereof. In some embodiments, the input device is a Kinect^{®}, Leap Motion^{®}, or the like. Input device(s) 733 may be interfaced to bus 740 via any of a variety of input interfaces 723 (e.g., input interface 723) including, but not limited to, serial, parallel, game port, USB, FIREWIRE, THUNDERBOLT, or any combination of the above.

In particular embodiments, when computer system 700 is connected to network 730, computer system 700 may communicate with other devices, specifically mobile devices and enterprise systems, distributed computing systems, cloud storage systems, cloud computing systems, and the like, connected to network 730. Communications to and from computer system 700 may be sent through network interface 720. For example, network interface 720 may receive incoming communications (such as requests or responses from other devices) in the form of one or more packets (such as Internet Protocol (IP) packets) from network 730, and computer system 700 may store the incoming communications in memory 703 for processing. Computer system 700 may similarly store outgoing communications (such as requests or responses to other devices) in the form of one or more packets in memory 703 and communicated to network 730 from network interface 720. Processor(s) 701 may access these communication packets stored in memory 703 for processing.

Examples of the network interface 720 include, but are not limited to, a network interface card, a modem, and any combination thereof. Examples of a network 730 or network segment 730 include, but are not limited to, a distributed computing system, a cloud computing system, a wide area network (WAN) (e.g., the Internet, an enterprise network), a local area network (LAN) (e.g., a network associated with an office, a building, a campus or other relatively small geographic space), a telephone network, a direct connection between two computing devices, a peer-to-peer network, and any combinations thereof. A network, such as network 730, may employ a wired and/or a wireless mode of communication. In general, any network topology may be used.

Information and data can be displayed through a display 732. Examples of a display 732 include, but are not limited to, a cathode ray tube (CRT), a liquid crystal display (LCD), a thin film transistor liquid crystal display (TFT-LCD), an organic liquid crystal display (OLED) such as a passive-matrix OLED (PMOLED) or active-matrix OLED (AMOLED) display, a plasma display, and any combinations thereof. The display 732 can interface to the processor(s) 701, memory 703, and fixed storage 708, as well as other devices, such as input device(s) 733, via the bus 740. The display 732 is linked to the bus 740 via a video interface 722, and transport of data between the display 732 and the bus 740 can be controlled via the graphics control 721. In some embodiments, the display is a video projector. In some embodiments, the display is a head-mounted display (HMD) such as a VR headset. In further embodiments, suitable VR headsets include, by way of non-limiting examples, HTC Vive^{®}, Oculus Rift^{®}, Samsung Gear VR^{®}, Microsoft HoloLens^{®}, Razer OSVR^{®}, FOVE VR^{®}, Zeiss VR One^{®}, Avegant Glyph^{®}, Freefly VR^{®} headset, and the like. In still further embodiments, the display is a combination of devices such as those disclosed herein.

In addition to a display 732, computer system 700 may include one or more other peripheral output devices 734 including, but not limited to, an audio speaker, a printer, a storage device, and any combinations thereof. Such peripheral output devices may be connected to the bus 740 via an output interface 724. Examples of an output interface 724 include, but are not limited to, a serial port, a parallel connection, a USB port, a FIREWIRE port, a THUNDERBOLT port, and any combinations thereof.

In addition or as an alternative, computer system 700 may provide functionality as a result of logic hardwired or otherwise embodied in a circuit, which may operate in place of or together with software to execute one or more processes or one or more steps of one or more processes described or illustrated herein. Reference to software in this present disclosure may encompass logic, and reference to logic may encompass software. Moreover, reference to a computer-readable medium may encompass a circuit (such as an IC) storing software for execution, a circuit embodying logic for execution, or both, where appropriate. The present disclosure encompasses any suitable combination of hardware, software, or both.

Various illustrative logical blocks, modules, circuits, and algorithm steps described in connection with the embodiments disclosed herein may be implemented as electronic hardware, computer software, or combinations of both. To clearly illustrate this interchangeability of hardware and software, various illustrative components, blocks, modules, circuits, and steps have been described above generally in terms of their functionality.

The various illustrative logical blocks, modules, and circuits described in connection with the embodiments disclosed herein may be implemented or performed with a general purpose processor, a digital signal processor (DSP), an application specific integrated circuit (ASIC), a field programmable gate array (FPGA) or other programmable logic device, discrete gate or transistor logic, discrete hardware components, or any combination thereof designed to perform the functions described herein. A general purpose processor may be a microprocessor, but in the alternative, the processor may be any conventional processor, controller, microcontroller, or state machine. A processor may also be implemented as a combination of computing devices, e.g., a combination of a DSP and a microprocessor, a plurality of microprocessors, one or more microprocessors in conjunction with a DSP core, or any other such configuration.

The steps of a method or algorithm described in connection with the embodiments disclosed herein may be embodied directly in hardware, in a software module executed by one or more processor(s), or in a combination of the two. A software module may reside in RAM memory, flash memory, ROM memory, EPROM memory, EEPROM memory, registers, hard disk, a removable disk, a CD-ROM, or any other form of storage medium. An exemplary storage medium is coupled to the processor such the processor can read information from, and write information to, the storage medium. In the alternative, the storage medium may be integral to the processor. The processor and the storage medium may reside in an ASIC. The ASIC may reside in a user terminal. In the alternative, the processor and the storage medium may reside as discrete components in a user terminal.

In accordance with the description herein, suitable computing devices include, by way of non-limiting examples, server computers, desktop computers, laptop computers, notebook computers, sub-notebook computers, netbook computers, netpad computers, set-top computers, media streaming devices, handheld computers, Internet appliances, mobile smartphones, tablet computers, personal digital assistants, video game consoles, and vehicles. Select televisions, video players, and digital music players with optional computer network connectivity are suitable for use in the system described herein. Suitable tablet computers, in various embodiments, include those with booklet, slate, and convertible configurations.

In some embodiments, the computing device includes an operating system configured to perform executable instructions. The operating system is, for example, software, including programs and data, which manages the device's hardware and provides services for execution of applications. Suitable server operating systems include, by way of non-limiting examples, FreeBSD^{®}, OpenBSD^{®}, NetBSD^{®}, Linux^{®}, Apple^{®} Mac OS X Server^{®}, Oracle Solaris^{®}, Windows Server^{®}, and Novell NetWare^{®}. Suitable personal computer operating systems include, by way of non-limiting examples, Microsoft Windows^{®}, Apple Mac^{®} OS X, UNIX^{®}, and UNIX-like operating systems such as GNU/Linux^{®}. In some embodiments, the operating system is provided by cloud computing. Suitable mobile smartphone operating systems include, by way of non-limiting examples, Nokia Symbian^{®} OS, Apple^{®} iOS, Research In Motion BlackBerry^{®} OS, Google^{®} Android^{®}, Microsoft^{®} Windows Phone^{®} OS, Microsoft^{®} Windows Mobile OS, Linux^{®}, and Palm^{®} WebOS. Suitable media streaming device operating systems include, by way of non-limiting examples, Apple TV^{®}, Roku^{®}, Boxee^{®}, Google TV^{®}, Google Chromecast^{®}, Amazon Fire^{®}, and Samsung^{®} HomeSync^{®}. Suitable video game console operating systems include, by way of non-limiting examples, Sony^{®} PS3^{®}, Sony^{®} PS4^{®}, Microsoft^{®} Xbox 360^{®}, Microsoft Xbox One^{®}, Nintendo Wii^{®}, Nintendo Wii U^{®}, and Ouya^{®}. Suitable virtual reality headset systems include, by way of non-limiting example, Meta Oculus^{®}.

### Non-transitory computer readable storage mediums

In some embodiments, the platforms, systems, media, and methods disclosed herein include one or more non-transitory computer readable storage media encoded with a program including instructions executable by the operating system of an optionally networked computing device. In further embodiments, a computer readable storage medium is a tangible component of a computing device. In still further embodiments, a computer readable storage medium is optionally removable from a computing device. In some embodiments, a computer readable storage medium includes, by way of non-limiting examples, CD-ROMs, DVDs, flash memory devices, solid state memory, magnetic disk drives, magnetic tape drives, optical disk drives, distributed computing systems including cloud computing systems and services, and the like. In some cases, the program and instructions are permanently, substantially permanently, semi-permanently, or non-transitorily encoded on the media.

### Computer programs

In another aspect, disclosed herein is a computer program product for predicting an overlay of a wafer, the computer program product comprising at least one non-transitory computer-readable medium having computer-readable program code portions embodied therein, the computer-readable program code portions comprising: an executable portion configured to receive a machine data set comprising parameters at a plurality of positions of a wafer, wherein the wafer is to be patterned by a machine to yield a patterned wafer; an executable portion configured to generate an integrated data set by (i) aggregating the parameters and (ii) mapping the aggregated parameters to an equispatial grid; an executable portion configured to generate, using a trained machine learning (ML) model, a predicted overlay for the patterned wafer based at least in part on processing the integrated data set; and an executable portion configured to infer a statistical deviation of the predicted overlay from a normally patterned wafer.

In some embodiments, the platforms, systems, media, and methods disclosed herein include at least one computer program, or use of the same. A computer program includes a sequence of instructions, executable by one or more processor(s) of the computing device's CPU, written to perform a specified task. Computer readable instructions may be implemented as program modules, such as functions, objects, Application Programming Interfaces (APIs), computing data structures, and the like, that perform particular tasks or implement particular abstract data types. In light of the present disclosure provided herein, a computer program may be written in various versions of various languages.

The functionality of the computer readable instructions may be combined or distributed as desired in various environments. In some embodiments, a computer program comprises one sequence of instructions. In some embodiments, a computer program comprises a plurality of sequences of instructions. In some embodiments, a computer program is provided from one location. In other embodiments, a computer program is provided from a plurality of locations. In various embodiments, a computer program includes one or more software modules. In various embodiments, a computer program includes, in part or in whole, one or more web applications, one or more mobile applications, one or more standalone applications, one or more web browser plug-ins, extensions, add-ins, or add-ons, or combinations thereof.

### Web applications

In some embodiments, a computer program includes a web application. In light of the present disclosure provided herein, a web application, in various embodiments, utilizes one or more software frameworks and one or more database systems. In some embodiments, a web application is created upon a software framework such as Microsoft^{®} .NET or Ruby on Rails^{®} (RoR). In some embodiments, a web application utilizes one or more database systems including, by way of non-limiting examples, relational, non-relational, object oriented, associative, and XML database systems. In further embodiments, suitable relational database systems include, by way of non-limiting examples, Microsoft^{®} structured query language (SQL) Server, mySQL^{™}, and Oracle^{®}. A web application, in various embodiments, is written in one or more versions of one or more languages. A web application may be written in one or more markup languages, presentation definition languages, client-side scripting languages, server-side coding languages, database query languages, or combinations thereof. In some embodiments, a web application is written to some extent in a markup language such as Hypertext Markup Language (HTML), Extensible Hypertext Markup Language (XHTML), or eXtensible Markup Language (XML). In some embodiments, a web application is written to some extent in a presentation definition language such as Cascading Style Sheets (CSS). In some embodiments, a web application is written to some extent in a client-side scripting language such as Asynchronous Javascript and XML^{®} (AJAX), Flash Actionscript, Javascript^{®}, or Silverlight^{®}. In some embodiments, a web application is written to some extent in a server-side coding language such as Active Server Pages^{®} (ASP), ColdFusion^{®}, Perl^{®}, Java^{®}, JavaServer Pages^{®} (JSP), Hypertext Preprocessor^{®} (PHP), Python^{®}, Ruby^{®}, Tcl^{®}, Smalltalk^{®}, WebDNA^{®}, or Groovy^{®}. In some embodiments, a web application is written to some extent in a database query language such as Structured Query Language (SQL). In some embodiments, a web application integrates enterprise server products such as IBM Lotus Domino^{®}. In some embodiments, a web application includes a media player element. In various further embodiments, a media player element utilizes one or more of many suitable multimedia technologies including, by way of non-limiting examples, Adobe^{®} Flash^{®}, HTML 5, Apple^{®} QuickTime^{®}, Microsoft Silverlight^{®}, Java^{®}, and Unity^{®}.

Referring to **FIG. 8****,** in a particular embodiment, an application provision system comprises one or more databases 800 accessed by a database management system (DBMS) 810. Suitable DBMSs include Firebird^{®}, MySQL^{®}, NoSQL^{®}, PostgreSQL^{®}, SQLite^{®}, Oracle Database^{®}, Microsoft SQL Server^{®}, IBM DB2^{®}, IBM Informix^{®}, SAP Sybase^{®}, SAP Sybase^{®}, Teradata^{®}, PostGIS^{®}, Apache^{®} Hive, Apache^{®} Impala, time-series databases, graph databases, key-value storage, and the like. In this embodiment, the application provision system further comprises one or more application severs 820 (such as Java^{®} servers, .NET^{®} servers, PHP^{®} servers, and the like) and one or more web servers 830 (such as Apache^{®}, IIS^{®}, GWS^{®} and the like). The web server(s) optionally expose one or more web services via app application programming interfaces (APIs) 840. Via a network, such as the Internet, the system provides browser-based and/or mobile native user interfaces. In some cases, a DBMS may be a relational DBMS.

Referring to **FIG. 9****,** in a particular embodiment, an application provision system alternatively has a distributed, cloud-based architecture 900 and comprises elastically load balanced, auto-scaling web server resources 910 and application server resources 920 as well synchronously replicated databases 930.

### Mobile applications

In some embodiments, a computer program includes a mobile application provided to a mobile computing device. In some embodiments, the mobile application is provided to a mobile computing device at the time it is manufactured. In other embodiments, the mobile application is provided to a mobile computing device via the computer network described herein.

In view of the present disclosure provided herein, a mobile application is created by techniques using hardware, languages, and development environments. Mobile applications are written in several languages. Suitable programming languages include, by way of non-limiting examples, C, C++, C#, Objective-C, Java^{®}, Javascript^{®}, Pascal^{®}, Object Pascal^{®}, Python^{™}, Ruby^{®}, VB.NET^{®}, WML^{®}, and XHTML/HTML with or without CSS, or combinations thereof.

Suitable mobile application development environments are available from several sources. Commercially available development environments include, by way of non-limiting examples, AirplaySDK^{®}, alcheMo^{®}, Appcelerator^{®}, Celsius^{®}, Bedrock^{®}, Flash Lite^{®}, .NET Compact Framework^{®}, Rhomobile^{®}, and WorkLight Mobile Platform^{®}. Other development environments are available without cost including, by way of non-limiting examples, Lazarus^{®}, MobiFlex^{®}, MoSync^{®}, and Phonegap^{®}. Also, mobile device manufacturers distribute software developer kits including, by way of non-limiting examples, iPhone^{®} and iPad^{®} (iOS) SDK, Android^{®} SDK, BlackBerry^{®} SDK, BREW SDK, Palm^{®} OS SDK, Symbian^{®} SDK, webOS^{®} SDK, and Windows^{®} Mobile SDK.

Several commercial sources are available for distribution of mobile applications including, by way of non-limiting examples, Apple^{®} App Store, Google^{®} Play, Chrome^{®} WebStore, BlackBerry^{®} App World, App Store^{®} for Palm devices, App Catalog^{®} for webOS, Windows^{®} Marketplace for Mobile, Ovi Store for Nokia^{®} devices, Samsung^{®} Apps, and Nintendo^{®} DSi Shop.

### Standalone applications

In some embodiments, a computer program includes a standalone application, which is a program that is run as an independent computer process, not an add-on to an existing process, e.g., not a plug-in. Standalone applications are often compiled. A compiler is a computer program(s) that transforms source code written in a programming language into binary object code such as assembly language or machine code. Suitable compiled programming languages include, by way of non-limiting examples, C, C++, Objective-C^{®}, COBOL^{®}, Delphi^{®}, Eiffel^{®}, Java^{®}, Lisp^{®}, Python^{®}, Visual Basic^{®}, and VB .NET^{®}, or combinations thereof. Compilation is often performed, at least in part, to create an executable program. In some embodiments, a computer program includes one or more executable compiled applications. Additionally, microservices related to Python^{®} and JavaScript^{®} may be used.

### Web browser plug-ins

In some embodiments, the computer program includes a web browser plug-in (e.g., web extension, etc.). In computing, a plug-in is one or more software components that add specific functionality to a larger software application. Makers of software applications support plug-ins to enable third-party developers to create abilities which extend an application, to support easily adding new features, and to reduce the size of an application. When supported, plug-ins enable customizing the functionality of a software application. For example, plug-ins are commonly used in web browsers to play video, generate interactivity, scan for viruses, and display particular file types. Several web browser plug-ins may include Adobe Flash Player^{®}, Microsoft Silverlight^{®}, and Apple QuickTime^{®}. In some embodiments, the toolbar comprises one or more web browser extensions, add-ins, or add-ons. In some embodiments, the toolbar comprises one or more explorer bars, tool bands, or desk bands.

In view of the present disclosure provided herein, several plug-in frameworks are available that enable development of plug-ins in various programming languages, including, by way of non-limiting examples, C++, Delphi^{®}, Java^{®}, PHP^{®}, Python^{®}, and VB .NET^{®}, or combinations thereof.

Web browsers (also called Internet browsers) are software applications, designed for use with network-connected computing devices, for retrieving, presenting, and traversing information resources on the World Wide Web. Suitable web browsers include, by way of non-limiting examples, Microsoft Internet Explorer^{®}, Mozilla Firefox^{®}, Google Chrome^{®}, Apple Safari^{®}, Opera Software Opera^{®}, and KDE Konqueror^{®}. In some embodiments, the web browser is a mobile web browser. Mobile web browsers (also called microbrowsers, mini-browsers, and wireless browsers) are designed for use on mobile computing devices including, by way of non-limiting examples, handheld computers, tablet computers, netbook computers, subnotebook computers, smartphones, music players, personal digital assistants (PDAs), and handheld video game systems. Suitable mobile web browsers include, by way of non-limiting examples, Google Android^{®} browser, RIM BlackBerry^{®} Browser, Apple Safari^{®}, Palm Blazer^{®}, Palm WebOS^{®} Browser, Mozilla Firefox^{®} for mobile, Microsoft Internet Explorer Mobile^{®}, Amazon Kindle Basic Web^{®}, Nokia Browser^{®}, Opera Software Opera Mobile^{®}, and Sony PSP^{®} browser.

### Software modules

In some embodiments, the platforms, systems, media, and methods disclosed herein include software, server, and/or database modules, or use of the same. In view of the present disclosure provided herein, software modules are created by techniques using machines, software, and languages. The software modules disclosed herein are implemented in a multitude of ways. In various embodiments, a software module comprises a file, a section of code, a programming object, a programming structure, or combinations thereof. In further various embodiments, a software module comprises a plurality of files, a plurality of sections of code, a plurality of programming objects, a plurality of programming structures, or combinations thereof. In various embodiments, the one or more software modules comprise, by way of non-limiting examples, a web application, a mobile application, and a standalone application. In some embodiments, software modules are in one computer program or application. In other embodiments, software modules are in more than one computer program or application. In some embodiments, software modules are hosted on one machine. In other embodiments, software modules are hosted on more than one machine. In further embodiments, software modules are hosted on a distributed computing platform such as a cloud computing platform. In some embodiments, software modules are hosted on one or more machines in one location. In other embodiments, software modules are hosted on one or more machines in more than one location.

### Databases

In some embodiments, the platforms, systems, media, and methods disclosed herein include one or more databases (DB), or use of the same. In view of the present disclosure provided herein, many databases are suitable for storage and retrieval data. In various embodiments, suitable databases include, by way of non-limiting examples, relational databases, non-relational databases, object oriented databases, object databases, entity-relationship model databases, associative databases, XML databases, time-series databases, graph databases, and the like. Further non-limiting examples include SQL, PostgreSQL^{®}, MySQL^{®}, Oracle^{®}, DB2^{®}, and Sybase. In some embodiments, a database is internet-based. In further embodiments, a database is web-based. In still further embodiments, a database is cloud computing-based. In a particular embodiment, a database is a distributed database. In other embodiments, a database is based on one or more local computer storage devices.

### Terms and Definitions

Unless otherwise defined, all technical terms used herein have the same meaning as commonly understood by one of ordinary skill in the art to which this present disclosure belongs.

As used herein, the singular forms "a," "an," and "the" include plural references unless the context clearly dictates otherwise. Any reference to "or" herein is intended to encompass "and/or" unless otherwise stated.

As used herein, the term "about" in some cases refers to an amount that is approximately the stated amount.

As used herein, the term "about" refers to an amount that is near the stated amount by 10%, 5%, or 1%, including increments therein.

As used herein, the term "about" in reference to a percentage refers to an amount that is greater or less the stated percentage by 10%, 5%, or 1%, including increments therein.

As used herein, the phrases "at least one", "one or more", and "and/or" are open-ended expressions that are both conjunctive and disjunctive in operation. For example, each of the expressions "at least one of A, B and C", "at least one of A, B, or C", "one or more of A, B, and C", "one or more of A, B, or C" and "A, B, and/or C" means A alone, B alone, C alone, A and B together, A and C together, B and C together, or A, B and C together.

While preferred embodiments of the present disclosure have been shown and described herein, such embodiments are provided by way of example only. It is not intended that the present disclosure be limited by the specific examples provided within the specification. While the present disclosure has been described with reference to the aforementioned specification, the descriptions and illustrations of the embodiments herein are not meant to be construed in a limiting sense. Numerous variations, changes, and substitutions may occur without departing from the present disclosure. Furthermore, it shall be understood that all aspects of the present disclosure are not limited to the specific depictions, configurations, or relative proportions set forth herein which depend upon a variety of conditions and variables. It should be understood that various alternatives to the embodiments of the present disclosure described herein may be employed in practicing the present disclosure. It is therefore contemplated that the present disclosure shall also cover any such alternatives, modifications, variations, or equivalents. It is intended that the following claims define the scope of the present disclosure and that systems, methods and structures within the scope of these claims and their equivalents be covered thereby.

### EMBODIMENTS OF THE INVENTION

1. A method for predicting an overlay of a wafer, the method comprising:
   (a) receiving a machine data set comprising parameters at a plurality of positions of a wafer, wherein the wafer is to be patterned by a machine to yield a patterned wafer;
   (b) generating an integrated data set by (i) aggregating the parameters and (ii) mapping the aggregated parameters to an equispatial grid;
   (c) generating, using a trained machine learning (ML) model, a predicted overlay for the patterned wafer based at least in part on processing the integrated data set; and
   (d) inferring a statistical deviation of the predicted overlay from a normally patterned wafer.
2. The method of embodiment 1, wherein the machine data set is a multimodal data set comprising alignment data, leveling data, lens data, servo data, advanced process control (APC) data, or fault detection and classification (FDC) data.
3. The method of embodiment 1, wherein the plurality of positions of the machine data set comprises positions across the patterned wafer that are random, uniformly distributed, or nonuniformly distributed.
4. The method of embodiment 1, further comprising applying an estimation function to the predicted overlay to predict a measurement at a plurality of other positions different than the plurality of positions of the predicted overlay.
5. The method of embodiment 1, wherein the plurality of other positions of the predicted overlay comprises positions across the patterned wafer that are random, uniformly distributed, or nonuniformly distributed.
6. The method of embodiment 1, further comprising re-patterning the patterned wafer when the statistical deviation is determined to be outside a prescribed threshold.
7. The method of embodiment 1, further comprising using the predicted overlay to adjust parameters of the machine before patterning a subsequent wafer by the machine.
8. The method of embodiment 1, further comprising using the predicted overlay to predict a drift or a shift in the machine or processes of the machine.
9. The method of embodiment 1, wherein measurements of the overlay or the predicted overlay comprise a critical dimension (CD) or a film thickness.
10. The method of embodiment 1, wherein measurements of the overlay or the predicted overlay comprise a spatial difference or a displacement between layers of the patterned wafer.
11. The method of embodiment 1, further comprising using the predicted overlay to predict an anomaly in the patterned wafer.
12. The method of embodiment 1, further comprising, before patterning a subsequent wafer, using the predicted overlay to adjust (i) one or more parameters of the machine or (ii) one or more process parameters of the machine.
13. The method of embodiment 1, wherein a process of the machine comprises a lithography process, an etching process, or a thin film process.
14. The method of embodiment 1, further comprising adjusting a density of the equispatial grid based at least on user-defined criteria or the statistical deviation.
15. The method of embodiment 1, wherein the predicted overlay is operable for performing advanced process control (APC) by:
   using the predicted overlay to determine parameters of the APC; and
   adjusting parameters of the machine in real time based at least on using the determined parameters,
   wherein the adjusted parameters improve a yield of subsequent wafers to be patterned by the machine by at least 1%.
16. The method of embodiment 1, wherein the trained ML model is trained using at least one or more of (i) the equispatial grid, (ii) the integrated data set, or (iii) a measured overlay of the patterned wafer.
17. The method of embodiment 16, further comprising using transfer learning to update a portion of the trained ML model before patterning a subsequent wafer, wherein the transfer learning is based at least on analyzing recent trends between the machine data set and the measured overlay.
18. The method of embodiment 1, further comprising training the ML model using one or more machine data sets comprising parameters from two or more machines used to pattern the wafer.
19. The method of embodiment 1, further comprising training the ML model using one or more overlays comprising measurements from two or more machines used to pattern the wafer.
20. The method of embodiment 1, wherein the trained ML model is a deep neural network comprising:
   an encoder layer configured to obtain (i) global context features of the patterned wafer and (ii) intra-input feature correlation;
   a decoder layer configured to determine the global context features of the patterned wafer; and
   a skip connection layer configured to use at least local context features and the intra-input feature correlation to generate the predicted overlay.
21. The method of embodiment 1, wherein the trained ML model is configured to preserve a spatial scale of any feature of the predicted overlay.
22. The method of embodiment 1, wherein the statistical deviation comprises a mean deviation or a sigma deviation.
23. The method of embodiment 1, wherein the predicted overlay is operable for performing virtual metrology (VM), root cause analysis (RCA), or image metrology (IM).
24. The method of embodiment 1, further comprising repeating (a) - (d) until all layers of the patterned wafer are patterned by the machine.
25. A computer program product for predicting an overlay of a wafer, the computer program product comprising at least one non-transitory computer-readable medium having computer-readable program code portions embodied therein, the computer-readable program code portions comprising:
   an executable portion configured to receive a machine data set comprising parameters at a plurality of positions of a wafer, wherein the wafer is to be patterned by a machine to yield a patterned wafer;
   an executable portion configured to generate an integrated data set by (i) aggregating the parameters and (ii) mapping the aggregated parameters to an equispatial grid;
   an executable portion configured to generate, using a trained machine learning (ML) model, a predicted overlay for the patterned wafer based at least in part on processing the integrated data set; and
   an executable portion configured to infer a statistical deviation of the predicted overlay from a normally patterned wafer.
26. A system for predicting an overlay of a wafer comprising at least one processor and instructions executable by the at least one processor to cause the at least one processor to perform operations comprising:
   (a) receiving a machine data set comprising parameters at a plurality of positions of a wafer, wherein the wafer is to be patterned by a machine to yield a patterned wafer;
   (b) generating an integrated data set by (i) aggregating the parameters and (ii) mapping the aggregated parameters to an equispatial grid;
   (c) generating, using a trained machine learning (ML) model, a predicted overlay for the patterned wafer based at least in part on processing the integrated data set; and
   (d) inferring a statistical deviation of the predicted overlay from a normally patterned wafer.

## Claims

1. A method for predicting an overlay of a wafer, the method comprising:
(a) receiving a machine data set comprising parameters at a plurality of positions of a wafer, wherein the wafer is to be patterned by a machine to yield a patterned wafer;
(b) generating an integrated data set by (i) aggregating the parameters and (ii) mapping the aggregated parameters to an equispatial grid;
(c) generating, using a trained machine learning (ML) model, a predicted overlay for the patterned wafer based at least in part on processing the integrated data set; and
(d) inferring a statistical deviation of the predicted overlay from a normally patterned wafer.

2. The method of claim 1, wherein the machine data set is a multimodal data set comprising alignment data, leveling data, lens data, servo data, advanced process control (APC) data, or fault detection and classification (FDC) data.

3. The method of claim 1, wherein the plurality of positions of the machine data set comprises positions across the patterned wafer that are random, uniformly distributed, or nonuniformly distributed.

4. The method of claim 1, further comprising applying an estimation function to the predicted overlay to predict a measurement at a plurality of other positions different than the plurality of positions of the predicted overlay.

5. The method of claim 1, further comprising re-patterning the patterned wafer when the statistical deviation is determined to be outside a prescribed threshold.

6. The method of claim 1, further comprising using the predicted overlay to (i) predict a drift or a shift in the machine or processes of the machine or (ii) predict an anomaly in the patterned wafer, or both.

7. The method of claim 1, wherein measurements of the overlay or the predicted overlay comprise a spatial difference or a displacement between layers of the patterned wafer.

8. The method of claim 1, further comprising, before patterning a subsequent wafer, using the predicted overlay to adjust (i) one or more parameters of the machine or (ii) one or more process parameters of the machine.

9. The method of claim 1, further comprising adjusting a density of the equispatial grid based at least on user-defined criteria or the statistical deviation.

10. The method of claim 1, wherein the predicted overlay is operable for performing advanced process control (APC) by:
using the predicted overlay to determine parameters of the APC; and
adjusting parameters of the machine in real time based at least on using the determined parameters,
wherein the adjusted parameters improve a yield of subsequent wafers to be patterned by the machine by at least 1%.

11. The method of claim 1, wherein the trained ML model is trained using at least one or more of (i) the equispatial grid, (ii) the integrated data set, or (iii) a measured overlay of the patterned wafer.

12. The method of claim 11, further comprising using transfer learning to update a portion of the trained ML model before patterning a subsequent wafer, wherein the transfer learning is based at least on analyzing recent trends between the machine data set and the measured overlay.

13. The method of claim 1, further comprising training the ML model using (i) one or more machine data sets comprising parameters from two or more machines used to pattern the wafer or (ii) one or more overlays comprising measurements from two or more machines used to pattern the wafer, or both.

14. The method of claim 1, wherein the trained ML model is a deep neural network comprising:
an encoder layer configured to obtain (i) global context features of the patterned wafer and (ii) intra-input feature correlation;
a decoder layer configured to determine the global context features of the patterned wafer; and
a skip connection layer configured to use at least local context features and the intra-input feature correlation to generate the predicted overlay.

15. The method of claim 1, wherein the trained ML model is configured to preserve a spatial scale of any feature of the predicted overlay.

16. A computer program product for predicting an overlay of a wafer, the computer program product comprising at least one non-transitory computer-readable medium having computer-readable program code portions embodied therein, the computer-readable program code portions comprising:
an executable portion configured to receive a machine data set comprising parameters at a plurality of positions of a wafer, wherein the wafer is to be patterned by a machine to yield a patterned wafer;
an executable portion configured to generate an integrated data set by (i) aggregating the parameters and (ii) mapping the aggregated parameters to an equispatial grid;
an executable portion configured to generate, using a trained machine learning (ML) model, a predicted overlay for the patterned wafer based at least in part on processing the integrated data set; and
an executable portion configured to infer a statistical deviation of the predicted overlay from a normally patterned wafer.
